# EUROPÄISCHE PATENTSCHRIFT

(11) **EP 2 219 815 B1**
(45) Veröffentlichungstag und Bekanntmachung des Hinweises auf die Patenterteilung: **22.03.2017**
(21) Anmeldenummer: 08851646.3
(22) Anmeldetag: 20.11.2008
(51) Int. Cl.: B23K 26/04, G02B 7/28, G03F 7/20

(54) **LASERSTRAHLBEARBEITUNG**
LASER BEAM MACHINING
USINAGE PAR FAISCEAU LASER

(30) Priorität: 21.11.2007 DE 102007055530
(43) Veröffentlichungstag der Anmeldung: 25.08.2010
(73) Patentinhaber: Nanoscribe GmbH, 76344 Eggenstein-Leopoldshafen (DE)
(72) Erfinder: KEMPE, Michael, 07751 Jena (DE); WESTPHAL, Peter, 07743 Jena (DE); GRAU, Wolfgang, 07745 Jena (DE); VON FREYMANN, Georg, 76344 Eggenstein-Leopoldshafen (DE)
(74) Vertreter: DREISS Patentanwälte PartG mbB
(86) Internationale Anmeldenummer: PCT/EP2008/009840
(87) Internationale Veröffentlichungsnummer: WO 2009/065590

(56) Entgegenhaltungen:
- EP-A- 0 558 781
- WO-A-99/64929
- WO-A-03/060610
- WO-A-2007/144197
- DE-A1- 10 112 639

## Beschreibung

Die Erfindung bezieht sich auf eine Vorrichtung sowie ein Verfahren zur Laserstrahlbearbeitung eines Werkstückes durch Zwei-Photonen-Prozesse (siehe WO-A-03/060610).

Die Laserstrahlbearbeitung eines Werkstückes durch Zwei-Photonen-Prozesse erfolgt in der Regel durch Verstellung eines Laserstrahlfokus über bzw. in dem Werkstück und wird auch als Laserschreiben bzw. Laser-Scanning-Lithographie bezeichnet. Vorrichtungen und Verfahren hierfür sind im Stand der Technik bekannt und nutzen in der Regel die Polymerisation eines Werkstückes, z. B. eines photoempfindlichen Resist. Eine entsprechende Beschreibung findet sich z. B. in J.-M. Lourtioz, Nature Materials 3, 427 (2004) und M. Deubel et al., Nature Materials 3, 444 (2004). Ein Mikroskop zum Laserstrahlschreiben ist beispielsweise in US 5034613 beschrieben. Für das Laserstrahlschreiben geeignete Materialien sind beispielsweise in der Veröffentlichung Miller J. et al. "Laser-Scanning Lithography (LSL) for the Soft Lithographic Patterning of Cell-Adhesive Self-Assembled Monolayers", in Biotechnology and Bioengineering, vol. 93, no. 6, April 20, 2006, Seite 1060-1068 erläutert.

Dabei besteht das Ziel, eine sehr hohe Auflösung zu erreichen, weshalb Objektive mit hoher numerischer Apertur eingesetzt werden, um mit der Bearbeitungsgenauigkeit in einen Bereich weniger 100 nm vorzustoßen. Meist verwendet man Ölimmersionsobjektive mit einer numerischen Apertur von etwa 1,4. Die in das Werkstück zu schreibenden Strukturen selbst sind dabei meist einige 100 µm in allen Raumrichtungen ausgedehnt. Als geeignete Werkstückmaterialien kommen unter anderem photoempfindliche Lacke (Resists) zur Anwendung, die auf ein Deckglas aufgeschleudert wurden.

Für die Güte der Strukturierung sind neben der Auflösung auch die Reproduzierung der Nah- und Fernordnung sowie ein exakter Bezug zu mindestens einer Grenzfläche wesentlich. Es werden deshalb zum Scannen, d. h. zum Verstellen der Fokuslage im/am Werkstück meist hochpräzise Piezotische zum Bewegen des Werkstückes eingesetzt. Dabei ist zu gewährleisten, daß die Lage der Probe während eines möglicherweise langen Schreib-/Belichtungsprozesses sowohl quer zur optischen Achse (also lateral) als auch längs dazu (also axial) möglichst stabil bleibt. Dies, wie auch die genau absolute Referenzierung der Fokuslage ist für die Bearbeitung des Werkstückes bei bestimmten Herstellprozessen essentiell.

Es stellt sich jedoch das Problem, daß die Referenzierung der absoluten Lage des Fokus oft sehr schwierig oder gar nicht möglich ist und insbesondere sich während des Bearbeitungsvorganges ändern kann.

Weiter ist es im Stand der Technik bekannt, für Autofokusfunktionen Triangulationsverfahren, abbildende Verfahren mit Kontrastauswertung und die Positionsbestimmung mittels schräg gestellter konfokaler Spaltblende zu verwenden. Bei Triangulationsverfahren wird ein kollimierter Laserstrahl in die Pupillenebene eines Objektives eingespiegelt und aus dem Verlauf dieses Laserstrahls relativ zum Abbildungsstrahlengang auf die z-Position des von der Probe reflektierten Laserlichts geschlossen. Bei üblichen Größen von Werkstücken, die mit Laser-Scanning-Lithographie bearbeitet werden, wäre jedoch die Autofokusgüte solcher Systeme unzureichend. Auch sind Schwankungen dahingehend festzustellen, ob das Meßergebnis vom Zentrum oder am Rand des Werkstückes bzw. des verwendeten Detektors ermittelt wird. Üblicherweise wird ein Triangulationsverfahren deshalb iterativ ausgeführt, was verhältnismäßig zeitraubend ist.

Bei abbildenden Verfahren mit Kontrastauswertung wird eine Probe mit einer bestimmten Intensitätsverteilung beleuchtet, meist indem in eine Feldblendenebene eines Beleuchtungsstrahlengangs ein Gitter gestellt wird. Man nimmt eine Serie von Bildern mit unterschiedlichen Abständen zwischen Abbildungsoptik und Probe auf und ermittelt in dieser Serie das Bild mit dem höchsten Kontrast, dem dann der optimale Fokusabstand zugeordnet ist. Beispiele für eine Autofokuseinrichtung mittels Kontrastanalyse eines auf eine Probe projizierten Musters finden sich in der US 5604344 oder der US 6545756.

Die Tatsache, daß mittels Zwei-Photonen-Prozesse bearbeitete Werkstücke üblicherweise transparent sind, stellt hier jedoch ein Problem dar, da beispielsweise Strukturen im Werkstück aufgrund dessen Transparenz nicht vorliegen.

Weiter ist z. B. aus der DE 10319182 A1 bekannt, eine Positionsbestimmung mittels schräg gestellter konfokaler Spaltblende indem in eine Feldblendenebene des Beleuchtungsstrahlengangs eine Spaltblende gestellt und auf die Probe abgebildet wird. Das von der Probe reflektierte Licht wird auf eine relativ zur Spaltblende geneigt angeordnete CCD-Zeile gerichtet und es wird die Position auf der CCD-Zeile bestimmt, an dem das reflektierte Licht ein Maximum hat. Dieses Verfahren ist sehr schnell, hat allerdings Probleme mit Verunreinigungen auf der Probe oder Probenoberfläche, die zu Intensitätsschwankungen führen können. Auch ist ein sehr großer Justieraufwand bei der Abbildung des Spaltes auf die CCD-Zeile aufzubringen, denn der Spalt muß, um eine hohe Genauigkeit erreichen zu können, sehr schmal sein. Vor allem ist aber die Spaltblende am Rand des Bildfeldes des Objektives wirksam, was die Genauigkeit erheblich begrenzt. Dieser Ansatz kann deshalb für Laser-Scanning-Lithographie nicht herangezogen werden.

Allen Verfahren ist zudem gemein, daß sie die Fokusebene zwar sehr genau finden können, jedoch die Lage dieser Fokusebene innerhalb der Probe, insbesondere bezüglich weiterer Grenzflächen, nur eingeschränkt zu ermitteln erlauben.

Mehrere Autofokusstrahlengänge zu verwenden, ist beispielsweise in der WO 00/43820 beschrieben. Die DE 10112639 A1 beschreibt ein Mikroskop mit Antofokussiereinrichtung. Der WO 99/64929 ist ein Laser-Scanning-System zur Photoresistbelichtung zu entnehmen.

Der Erfindung liegt deshalb die Aufgabe zugrunde, ein Verfahren bzw. eine Vorrichtung anzugeben, mit dem/der die Laserstrahlbearbeitung transparenter Werkstücke mittels Zwei-Photonen-Prozessen hochpräzise möglich ist.

Zur Lösung dieser Aufgabe ist erfindungsgemäß ein Verfahren zur Laserstrahlbearbeitung eines Werkstückes vorgesehen, wobei ein Laserstrahl in oder auf das eine Grenzfläche aufweisende Werkstück zum Erzeugen eines Bearbeitungseffektes mittels Zwei-Photonen-Prozessen durch ein Objektiv, das eine Fokusebene aufweist, in einem Fokus gebündelt wird und die Lage des Fokus gegenüber dem Werkstück verstellt wird, wobei zur Referenzierung der Lage des Fokus ebenfalls durch das Objektiv ein leuchtendes Modulationsobjekt auf das Werkstück in die Fokusebene oder diese schneidend abgebildet wird und an der Grenzfläche auftretende Reflexe der Abbildung in eine Autofokus-Bildebene abgebildet wird und mit einer eine Kamera-Bildebene aufweisenden Kamera detektiert werden, wobei die Kamera-Bildebene entweder die Autofokus-Bildebene schneidet, wenn das Bild des leuchtenden Modulationsobjektes in der Fokusebene liegt, oder in der Autofokus-Bildebene liegt, wenn das Bild des Modulationsobjektes die Fokusebene schneidet.

Weiter löst die Erfindung die Aufgabe mit einem Mikroskop zum Laserbearbeiten eines Werkstückes mittels Zwei-Photonen-Prozessen, das aufweist: ein Objektiv, das eine in einem Werkstückaufnahmeraum liegende Fokusebene aufweist, eine Bearbeitungslaserstrahlquelle, die Bearbeitungslaserstrahlung abgibt, welche das Objektiv in den Werkstückaufnahmeraum fokussiert, und eine Autofokuseinrichtung, die umfaßt einen Lichtmodulator zur Erzeugung eines leuchtenden, intensitätsmodulierten Modulationsobjektes, eine Autofokus-Optik, die zusammen mit dem Objektiv das leuchtende Modulationsobjekt in die Fokusebene oder diese schneidend abbildet, so daß im Werkstückaufnahmeraum ein Bild des Modulationsobjektes entsteht, eine Kamera zur Aufnahme eines zweidimensionalen Bildes, die eine Kamera-Bildebene hat, und eine Autofokus-Abbildungsoptik, die zusammen mit dem Objektiv das im Werkstückaufnahmeraum liegende Bild des Modulationsobjektes in eine Autofokus-Bildebene abbildet, wobei die Kamera-Bildebene entweder die Autofokus-Bildebene schneidet, wenn das Bild des Modulationsobjektes in der Fokusebene liegt, oder in der Autofokus-Bildebene liegt, wenn das Bild des Modulationsobjektes die Fokusebene schneidet.

Die Erfindung löst die Aufgabe also, indem eine Autofokus-Funktion eingesetzt wird, die das Anfahren der Grenzfläche des Werkstückes mit hoher Präzision erlaubt, wobei eine eigenständige Autofokus-Abbildung eines leuchtenden Modulationsobjektes eingesetzt wird, das entweder schräg in die Grenzfläche abgebildet oder dessen Abbildung zur Grenzfläche schräg detektiert wird.

Bei einer spiegelnd reflektierenden Grenzfläche (wie sie z. B. zwischen Deckglas und Resist vorliegt), entsteht auf einem schrägen Autofokus-Detektor auch dann ein Kontrastsignal, wenn das Gitter viele Schäfentiefen vor oder hinter der Grenzfläche abgebildet wird. Dadurch erhält man einen verhältnismäßig großen Fangbereich bei diesem Autofokusprinzip.

Aufgrund der Abbildung/Detektion des leuchtenden Modulationsobjektes tritt dort, wo die Abbildung/Detektion des leuchtenden Modulationsobjektes die Grenzfläche schneidet, ein Rück-Reflex auf. Dieser Rück-Reflex wird nun detektiert, so daß aus der lateralen Lage des Reflexes die Fokussierung bzw. ein Grad der Defokussierung ermittelbar ist. Die derart bekannte Lage der Grenzfläche wird nun zur Referenzierung bei der Laserstrahlbearbeitung eingesetzt. Somit ist die exakte Lage des Fokus bezogen auf die Grenzfläche, z. B. eines Übergangs zwischen einem Deckglas und dem eigentlichen Werkstück möglich. Falls zu erwarten ist, daß während der Dauer der Laserstrahlbearbeitung eine Drift im System eintritt, kann die Referenzierung geeignet, z. B. intermittierend wiederholt werden, so daß auch bei einer nahezu beliebig lange dauernden Laserstrahlbearbeitung eine gleichbleibend hohe Präzision sichergestellt ist.

Für eine optimale Detektion der Grenzfläche, d. h. für eine optimale Autofokus-Funktion ist es vorteilhaft, in einem Spektralbereich zu arbeiten, in dem der Bearbeitungs-Laserstrahl nicht liegt. Es ist deshalb bevorzugt, daß das Modulationsobjekt in einem Spektralbereich leuchtet, der von dem des Laserstrahls verschieden ist, und daß der Spektralbereich des Laserstrahls bei der Detektion der Reflexe mit der Kamera ausgefiltert wird. Dies kann durch geeignete Filter im Detektionsstrahlengang erreicht werden.

Für eine von der Bearbeitungsdauer unabhängige Qualität ist es deshalb zu bevorzugen, daß während der Laserstrahlbearbeitung zumindest intermittierend die Lage der Grenzfläche bestimmt wird und als Referenz für die Einstellung der Lage des Fokus verwendet wird.

Zur Erhöhung der Genauigkeit kann vor der eigentlichen Laserstrahlbearbeitung die Lage der Grenzfläche an verschiedene lateralen, also in unterschiedlichen Lagen zur optischen Achse liegenden Punkten bestimmt und durch eine Ebene modelliert werden. Die modellierte Ebene ist dann eine präzisiere Angabe für die Lage der Grenzfläche.

Eine sich dabei von der senkrechten zur optischen Achse ergebende Abweichung in Form einer Verkippung kann dann bei der späteren Laserstrahlbearbeitung berücksichtigt werden. Stellt sich heraus, daß einzelne oder mehrere laterale Punkte eine sehr große Ablage von der modellierten Ebene haben, kann daraus auf eine Deformation der Grenzfläche geschlossen werden. Eine solche ist natürlich ein Qualitätsparameter des Werkstückes. Es ist deshalb bevorzugt, daß aus Abständen der Lage der lateralen Punkte von der modellierten Ebene ein Maß über eine Abweichung der Grenzfläche von einer idealen Ebene ermittelt wird und dem Werkstück ein Qualitätsparameter zugeordnet wird, der auf dem Maß basiert. Bei einem bestimmten Qualitätsparameterbereich kann eine weitere Bearbeitung des Werkstückes unterbunden werden, beispielsweise weil seine Grenzfläche zu stark verformt ist.

Die Bearbeitung des Werkstückes erfolgt in der Regel durch dreidimensionale Fokusverstellung. Dazu kann wahlweise das Werkstück oder der Fokus bewegt werden. Dabei wird vorzugsweise der Fokus in Ebenen verstellt, die nacheinander jeweils vollständig abgearbeitet werden und die entweder parallel oder senkrecht zur Grenzfläche liegen, wobei für jede Ebene bzw. die Abarbeitung jeder Ebene jeweils eine Referenzierung auf die Grenzfläche erfolgt. Diese Referenzierung kann beispielsweise dadurch geschehen, indem vor dem Anfahren der nächsten Ebene eine erneute Bestimmung der Lage der Grenzfläche, d. h. der Referenz vorgenommen wird.

Vorzugsweise wird der Modulationskontrast mit einem statischen Transmissions- oder Reflexionsgitter erzeugt. Der Modulationskontrast kann beispielsweise als ein flächig ausgedehntes Streifengitter ausgelegt werden. Die Gitterperiode wird grundsätzlich möglichst klein gewählt, um eine hohe Autofokus-Auflösung zu erzielen. Die Gitterperiode muss allerdings so groß sein, dass auf der Autofokuskamera für den gesamten benötigten Fangbereich ein Modulationskontrast von mindestens 10% entsteht. Limitierend sind dabei die Randbereiche des Modulationsobjektes, da die sphärischen Abbildungsfehler aufgrund der Schrägstellung der Autofokuskamera am Bildfeldrand am größten sind. Demzufolge ist die Gitterperiode deutlich größer zu wählen als die Abbe-Auflösung des verwendeten Objektivs auf der optischen Achse. Um mit möglichst verschiedenen Werkstücken arbeiten zu können, ist es für das erfindungsgemäße Mikroskop bevorzugt, daß der Lichtmodulator ansteuerbar und zur Erzeugung eines räumlich oder zeitlich intensitätsmodulierten Modulationsobjektes angesteuert ist und die Kamera den Kontrast zu dieser zeitlichen Modulation erfaßt. Dann läßt sich der für die Lage der Grenzfläche ausgewertete Reflex durch eine geeignete zeitliche Filterung, z. B. in Lock-in-Technik von etwaigem Untergrundrauschen oder Störsignalen separieren. Der Lichtmodulator weist vorzugsweise ein beleuchtetes LCD- oder DMD-Element oder mindestens eine periodische Struktur auf, insbesondere eine Streifengitterstruktur oder mehrere unterschiedliche Streifenstrukturen.

Das Modulationsobjekt moduliert räumlich und kann bei Verwendung eines verstellbaren Lichtmodulators auch zusätzlich zeitlich modulieren. Eine zeitliche Modulation ist eine Alternative zu einer spektralen Trennung, um die Beleuchtung durch das Modulationsobjekt von der Bearbeitungslaserstrahlung zu unterscheiden. Hierbei ist vorzugsweise die Erfassung der Autofokusabbildung zur zeitlichen Modulation synchronisiert, z. B. kann eine Lock-In-Technik zum Einsatz kommen. Vorzugsweise erfolgt die zeitliche Modulation mit so hoher Frequenz, daß sie bei visueller Beobachtung im Mikroskop, z. B. durch ein Mikroskopokular nicht wahrnehmbar ist. Ein möglicher Frequenzbereich liegt oberhalb der Bildverschmelzungsfrequenz des Auges, die im helladaptierten Zustand etwa 50 Hz beträgt, beispielsweise zwischen 50 und 200 Hz ist ein möglicher Bereich.

Eine besonders genaue Bestimmung der Grenzflächenlage erreicht man, da die Abbildung des Objektes über dasselbe Objektiv erfolgt, das auch die Bearbeitungs-Laserstrahlung in/an das Werkstück fokussiert. Für eine einfache optische Anordnung ist es dabei bevorzugt, daß die Abbildung des Modulationsobjektes über einen Strahlteiler in den Mikroskopstrahlengang eingespiegelt ist.

Zusätzlich oder alternativ zu einer zeitlichen Diskriminierung der Abbildung, wie sie im vorvorherigen Absatz bereits erläutert wurde, ist auch eine spektrale Separation vorteilhaft. Für diese ist zweckmäßiger Weise vorgesehen, daß der Lichtmodulator in einem Autofokus-Spektralbereich leuchtet oder beleuchtet ist, der von dem der Bearbeitungslaserstrahlung verschieden ist, und die Autofokus-Abbildungsoptik mindestens einen Filter aufweist, der außerhalb des Autofokus-Spektralbereiches liegende Spektralanteile, insbesondere die der Bearbeitungslaserstrahlung, unterdrückt oder ausfiltert.

Die Ein- und Auskopplung der strukturierten Beleuchtung sowie der Abbildung der Reflexe am Werkstück auf die Kamera kann dann vorteilhafterweise mit einem Teilerspiegel erfolgen, der nur einen geringen Einfluß auf den übrigen Mikroskopstrahlengang hat, z. B. durch einen hohen Transmissionsgrad für die Bearbeitungsstrahlung (ca. 95 % und höher sind möglich). Besonders bevorzugt ist eine dichroitische Trennung in Kombination mit spektral separierter Autofokusstrahlung. Weiter ist es günstig, die/den Teiler einseitig zu entspiegeln, um den übrigen Mikroskopstrahlengang möglichst gering zu beeinflussen. Natürlich kann bei Bedarf der Reflexionsgrad aber auch auf Kosten des Transmissionsgrades erhöht werden. Arbeitet das Autofokussystem z. B. mit einer infraroten (NIR)-Beleuchtungsquelle, so ist vorzugsweise der dichroitischer Strahlteiler natürlich so ausgebildet, daß er die Autofokus-Strahlung mit hoher Effizienz im Autofokus-Strahlengang führt oder aus-/und einkoppelt.

In einer vereinfachten Bauweise kann natürlich auch das leuchtende Modulationsobjekt in Spektralbereichen leuchten, in der auch die Bearbeitungslaserstrahlung liegt, solange die Autofokus-Abbildungsoptik Spektralanteile der Bearbeitungslaserstrahlung unterdrückt oder ausfiltert.

Vorteilhaft erfolgt durch die Abbildung des Modulationsobjekts eine periodische Beleuchtung, z.B. Streifenbeleuchtung, bei der das Modulationsobjekt dann ein Streifenmuster ist. Auf der Kamera erscheint dann ein entsprechendes periodisches Muster, z.B. ein Streifenmuster, dessen Kontrast in der zur aktuellen Fokusebene konjugierten Ebene maximal ist. Hierdurch läßt sich ein sehr zuverlässiges und genaues Autofokussystem für die Grenzflächen des Werkstückes realisieren.

Sowohl der Lichtmodulator als auch die Autofokuskamera sind zweidimensional, also flächig ausgelegt. Jede Zeile der flächig auflösenden Autofokuskamera kann zur Erzeugung eines Autofokussignals verwendet werden. Da stets mehrere Zeilen beleuchtet werden, können die Autofokussignale mehrerer Zeilen gemittelt werden, was die Genauigkeit des Verfahrens erheblich erhöht.

Je weniger störende Untergrundreflexe vorliegen, desto ausgedehnter kann das Modulationsobjekt sein. Im Prinzip kann das komplette Objektfeld mit einer Gitterstruktur beleuchtet werden, so dass auch die flächige Autofokuskamera maximal ausgenutzt wird. Liegende jedoch störende Konkurrenzreflexe vor - insbesondere von der nicht an den Resist grenzenden Oberfläche des Deckglases (zur Luft hin) - so muss das Modulationsobjekt schmal ausgelegt werden, damit eine konfokale Unterdrückung der Konkurrenzreflexe erzielt wird. In einem solchen Fall, können nur wenige Zeilen, beispielsweise 10 bis 30, der Autofokuskamera beleuchtet und ausgewertet werden.

Um möglichst geringe Einflüsse durch die Abbildung des Modulationsobjektes zu erzeugen, ist bevorzugt die Struktur eines räumlich modulierten Modulationsobjektes in schneller Folge (z. B. mit größer als 30 Hz) alternierend lateral verschoben. Eine weitere Möglichkeit, die ebenfalls bei einem verstellbaren Lichtmodulator gegeben ist, besteht darin, immer oder zeitweise (z. B. nach Auffinden der Grenzfläche) nur noch bestimmte Teil-Bereiche des vom Objektiv erfaßten Objektfeldes/Werkstückraumes auszuleuchten. Hierdurch kann der Bildkontrast für den Autofokus erhöht werden.

Wesentlich für die Grenzflächendetektion ist, daß entweder das Modulationsobjekt schräg zur Fokusebene des Objektives oder die Kamera-Bildebene schräg zur Bildebene der Autofokus-Abbildungsoptik steht. Es können auch beide entsprechend schräg stehen. Die Schrägstellung kann dadurch erreicht werden, daß das Modulationsobjekt bzw. die Kamera schräg zur optischen Achse steht. Es kann also das Modulationsobjekt schräg zur optischen Achse und die Bildebene der Kamera senkrecht zur optischen Achse stehen, es kann das Modulationsobjekt senkrecht zur optischen Achse und die Bildebene der Kamera schräg zur optischen Achse stehen. Es ist auch möglich, sowohl das Modulationsobjekt als auch die Bildebene der Kamera schräg zu stellen, wobei diese dann aber nicht in konjugierten Ebenen stehen dürfen.

Bei allen Varianten des Mikroskops ist es vorzuziehen, eine rechnerische Auswertevorrichtung zu verwenden, die die Signalauswertung der Kamera(s) vornimmt, einen gegebenenfalls verstellbaren Lichtmodulator ansteuert und die Steuerung von gegebenenfalls vorhandenen mechanischen Stelleinheiten am Mikroskop (z. B. zur Fokusverstellung, zur x-y-Verstellung, zum Einschwenken und/oder Einschalten von Filtern etc.) vornimmt. Auswertung und Steuerung können sowohl schaltungs- als auch softwaretechnisch implementiert werden. Die Autofokuseinrichtung der Erfindung wird im Betrieb natürlich von einem Steuergerät gesteuert, das die rechnerische Auswertevorrichtung umfaßt und die hier erläuterten Maßnahmen einleitet, um die beschriebene Vorgehensweise zu realisieren. Bei dem Steuergerät kann es sich um ein ohnehin im Mikroskop vorgesehenes Steuergerät handeln.

In ungünstigen Fällen kann die Lichtmodulation, die auf der Kamera nachgewiesen wird, d. h. das Bild des in die Probe abgebildeten Objektes, durch Speckle-Effekte beeinträchtigt werden. Für derartige Zwecke kann es vorteilhaftig sein, das Werkstück oder das Modulationsobjekt und/oder ggf. die diese beleuchtende Lichtquelle gleichförmig oder periodisch zu bewegen, um Speckle-Muster herauszumitteln. Alternativ ist auch ein synchrones Bewegen von Modulationsobjekt und Kamera möglich.

Natürlich können weitere Kameras eingespiegelt werden, die Strukturinformationen von der Probe ableiten. Diese Kameras sind dann so angeordnet, daß auf Ihnen unterschiedliche Schnittebenen der Probe abgebildet werden, d. h. die Kameras sind mit unterschiedlichen Kippwinkeln zur optischen Achse bzw. unterschiedlichen Drehwinkeln um die optische Achse angeordnet.

Zur Erhöhung des Autofokus-Fangbereiches in z-Richtung kann zusätzlich noch eine Kamera in einer zum Lichtmodulator nicht-konjugierten Ebene angebracht sein. Durch den entsprechenden Verkippwinkel läßt sich der Fangbereich einstellen. Das Schrägstellen einer nicht-konjugiert angeordneten Kamera ist äquivalent zu einem geänderten Winkel, den das Modulationsobjekt mit der optischen Achse einschließt. Da dieser Winkel jedoch aus praktischen Gründen wegen sphärischen Bildfehlern und Reflexionsverlusten kaum kleiner als 30° gewählt werden kann, ergibt sich durch eine solche weitere Kamera die Möglichkeit, den Fangbereich der Autofokuseinrichtung zu erhöhen.

Das Mikroskop kann insbesondere als inverses Mikroskop ausgebildet sein.

Eine besonders gute Anpassung an verschiedene Werkstücke ist gegeben, wenn der Lichtmodulator ansteuerbar und zur Erzeugung eines räumlich oder zeitlich intensitätsmodulierten Modulationsobjektes ausgebildet ist. Diese Ansteuerbarkeit kann dadurch erreicht werden, daß als Lichtmodulator ein beleuchtetes LCD- oder DMD-Element verwendet wird. Die eingesetzte Wellenlänge unterscheidet sich vorzugsweise von der normalen Beleuchtungsstrahlung im Mikroskop. Prinzipiell kann die Autofokuseinrichtung hinsichtlich des Lichtmodulators und/oder der Kamera in den Strahlengang für die Bearbeitungsstrahlung eingekoppelt werden. Durch einen geeigneten Spektralfilter vor der Kamera der Autofokuseinrichtung kann potentiell störende Strahlung aus dem Mikroskop effektiv unterdrückt und bei der Autofokuseinrichtung ausgeblendet werden. Z. B. wird der Strahlteiler so ausgelegt, daß er nur einen schmalen Wellenlängenbereich, z.B. 20 nm, der sich nicht mit der Zwei-Photonen-Bearbeitungsstrahlung überschneidet, reflektiert. Grundsätzlich kann jedoch auch der gesamte sichtbare Bereich, sowie NIR und UV für die Autofokusfunktion verwendet werden.

Eine besonders einfache Analyse des in die Probe abgebildeten Modulationsobjektes erhält man, wenn das abgebildete Modulationsobjekt eine periodische Struktur, z. B. eine Streifengitterstruktur aufweist. Der Lichtmodulator ist also entsprechend ausgebildet.

Zweckmäßigerweise wird man die Autofokuseinrichtung in den Strahlengang des Mikroskops über einen Strahlteiler einspiegeln, wobei zugleich die Abbildung des Modulationsobjektes, wie auch die Rück-Abbildung des abgebildeten Modulationsobjektes auf die Kamera über denselben Strahlteiler eingekoppelt ist. Dies ist jedoch nicht zwingend.

Der Winkel der Schrägstellung von Bildebene der Kamera bzw. Modulationsobjekt zur optischen Achse stellt den Fangbereich bzw. Tiefenbereich ein, in dem die Autofokuseinrichtung arbeitet. Ein Winkel zwischen 20° und 70° ist zweckmäßig. Wie bereits erwähnt, kann man mehrere Kameras verwenden, deren Bildebenen zueinander, insbesondere unterschiedlich, geneigt sind.

Arbeitet man mit einer spektralen Separierung von Autofokusstrahlung und Bearbeitungsstrahlung, ist es natürlich vorteilhaft, die Spektralbereiche der Bearbeitungsstrahlung im Autofokusstrahlengang möglichst zu unterdrücken. Etwaige Anteile, die also z. B. einen dichroitischen Strahlteiler passieren und damit noch in den Autofokusstrahlengang gelangen, werden dann vorzugsweise durch geeignete Filter unterdrückt. Eine besonders gute Filterung ist möglich, wenn das in der Probe liegende Bild des Modulationsobjektes unter Einschaltung einer Zwischenabbildung auf die Kamera abgebildet wird. Dann besteht ausreichend Bauraum, um Sperrfilter einzusetzen.

Eine weitere Unterdrückung von störender Strahlung erreicht man, wenn man an dem Strahlteiler, der im Autofokusstrahlengang die Beleuchtung, d. h. die Abbildung des Modulationsobjektes auf das Werkstück, von der Detektion, d. h. die Abbildung des Reflexes auf die Kamera trennt, eine Strahlungsfalle vorsieht, die an diesem Strahlteiler transmittierte Strahlung, die nicht weiter verwertet wird, absorbiert.

Die Verwendung einer Zwischenabbildung hat weiter den erheblichen Vorteil, das zwischen dem Strahlteiler, der Autofokusbeleuchtung und Autofokusdetektion trennt, ein großer Abstand zu detektierenden Kamera besteht. Unvermeidbares Streulicht vom Strahlteiler gelangt so nur noch über Mehrfachreflexionen, d. h. stark abgeschwächt, zur Kamera. Durch die Verwendung einer Zwischenabbildung werden darüber hinaus noch Reflexe von Optiken, die zwischen dem Strahlteiler und der Kamera liegen, unterdrückt.

Die Erfindung wird nachfolgend unter Bezugnahme auf die Zeichnung beispielhalber noch näher erläutert. Es zeigen:
- Fig. 1: eine schematische Darstellung eines Mikroskopes zur Laser-Scanning-Lithographie,
- Fig. 2: einen Teil des Mikroskopes der Fig. 1 in detaillierter Ansicht,
- Fig. 3: das Mikroskop der Fig. 2 mit Darstellung der Autofokuseinrichtung,
- Fig. 4: das Mikroskop der Fig. 2 mit einer gegenüber Fig. 3 modifizierten Autofokuseinrichtung,
- Fig. 5: ein Mikroskop ähnlich dem der Fig. 3,
- Fig. 6: einen Graphen zur Erläuterung der Grenzflächenbestimmung bei einem Kalibrierschritt,
- Fig. 7: ein Mikroskop ähnlich dem der Fig. 3, mit einer Autofokuseinrichtung, in welcher einer Kamera eine Zwischenabbildungsoptik vorgeordnet ist,
- Fig. 8: eine Draufsicht auf einen exemplarischen Lichtmodulator, und
- Fig. 9 und 10: Kontrastsignale, die von einer Kamera der Autofokuseinrichtung der Fig. 3 oder 7 abgegeben werden.

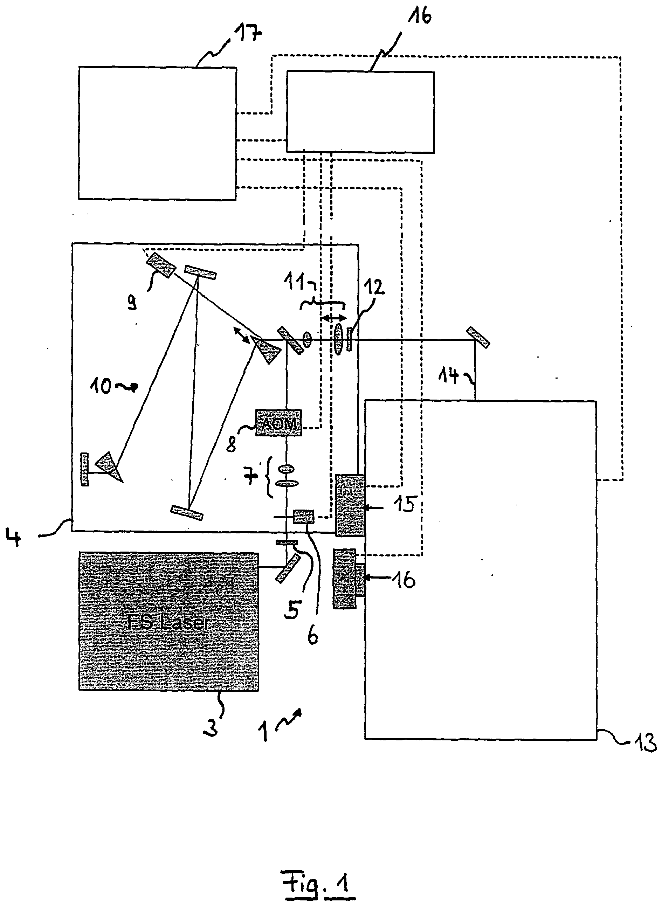

Fig. 1 zeigt ein Laser-Scanning-Mikroskop 1, mit dem in einem Werkstück, das z. B. eine Polymerschicht auf einem Substrat sein kann, mittels direktem Laserschreiben (also per Laser-Scanning-Lithographie) eine mehrdimensionale Struktur erzeugt wird. Dabei kommt ein Zwei-Photonenprozeß zum Einsatz.

Die Darstellung in Fig. 1 ist stark vereinfacht. Das Mikroskop 1 hat als Strahlquelle für das Laserschreiben einen gepulsten Laser 3, z. B. einen fs-Laser. Die Strahlung des Lasers 3, z. B. mit einer mittleren Wellenlänge von z. B. 780 nm, wird in einem Pulsaufbereiter 4 zu fs-Pulsen geformt. Dazu wird die Strahlung zuerst über eine λ/2-Platte 5, einen mechanischen Shutter 6, ein Teleskop 7 und einen akusto-optischen Modulator (AOM) 8 geleitet und damit in seiner Intensität gesteuert. Die Überwachung der Steuerung (z. B. per closed-loop Feedback) erfolgt über eine Monitordiode 9, welche einen Anteil der Strahlung empfängt.

Nach geeigneter Einstellung der Gruppengeschwindigkeitsdispersion (GVD) mittels einer GVD-Baugruppe 10, um kürzestmögliche (d. h. bandbreitenbegrenzte) Impulse in der Objektebene zu erhalten, wird der Strahl in einem verstellbaren Teleskop 11 aufgeweitet, über eine λ/4-Platte 12 und einen Umlenkspiegel zur Einkopplung am Mikroskopstrahlengang 13 geleitet, so daß dort eine optimale Ausleuchtung der Objektivpupille erfolgt. Die Einkopplung des derart bereitgestellten Bearbeitungslaserstrahles 14 am Mikroskopstrahlengang geschieht so, daß sich vor dessen Objektiv keine weiteren optischen Elemente außer Spiegel und Strahlteiler befinden. Das Objektiv fokussierte den Laserstrahl in das Werkstück, das auf einem Piezotisch befestigt ist. Der Piezotisch ist ein Beispiel für eine Scananordnung, die die Lage des Fokuspunktes auf dem bzw. im Werkstück verstellt.

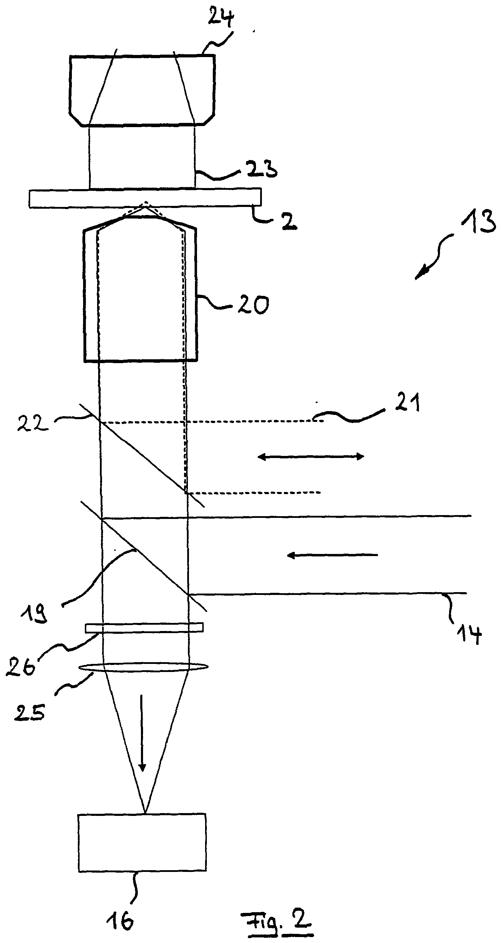

Neben einem noch genauer zu beschreibenden Autofokus-Detektor 15 weist der Mikroskopstrahlengang 15 noch eine Kamera 16 auf, mit der eine Kalibrierung des Autofokus vorgenommen werden und ein Bild der Probe, bevorzugt im Durchlicht, durch konventionelle, spektral gefilterte Beleuchtung mit einer Halogenlampe oder durch eine LED-Beleuchtung erhalten werden kann. Der Mikroskop-Strahlengang 13 mit der Ankopplung des AutofokusDetektors 15 und der Kamera 16 ist in Fig. 2 schematisch dargestellt.

Zur Steuerung des Lasers ist ein Lasersteuergerät 16 vorgesehen. Das gesamte Mikroskop 1 wird von einer Mikroskopsteuereinheit 17 gesteuert. Exemplarisch sind Steuerleitungen in Fig. 1 gestrichelt eingezeichnet.

Fig. 2 zeigt schematisch einen Teil des Mikroskopstrahlenganges 13. In diesen wird, wie anhand Fig. 1 bereits erläutert, der Bearbeitungslaserstrahl 14 über einen Strahlteiler 19 eingekoppelt. Der Strahlteiler 19 ist für die Wellenlänge der Bearbeitungsstrahlung, die beispielsweise bei 780 nm liegt, reflektiv. Insbesondere kann der Strahlteiler 19 als Dichroit ausgebildet werden, der Strahlung in einem Wellenlängenbereich oberhalb von 750 nm reflektiert, ansonsten jedoch transmittiert. Die derart eingekoppelte Bearbeitungslaserstrahlung 14 wird dann von einem Objektiv 20 auf oder in das Werkstück 2 fokussiert, um dort mittels Zwei-Photonen-Prozessen Veränderungen auszulösen, insbesondere eine dreidimensionale Struktur in einem Photolack oder Resist zu erzeugen.

Zwei-Photonen-Prozesse werden bekannterweise eingesetzt, um Materialien zu bearbeiten, die transmittiv sind, also einer Bearbeitung durch lineare Absorption nicht zugänglich sind. Zur Bewertung bzw. Beobachtung des somit in der Regel transparenten Werkstückes 2 dient die Kamera 16, deren Einbindung in den Strahlengang nachfolgend noch erläutert werden wird.

Für das direkte Laserschreiben mittels des Bearbeitungslaserstrahls 14 ist eine Autofokuseinrichtung an dem Mikroskopstrahlengang 13 angebunden, deren Autofokusstrahlengang 21 über einen Strahlteiler 22 in den Strahlengang der Bearbeitungslaserstrahlung und damit vor dem Objektiv 20 angekoppelt ist. Für den Autofokusstrahlengang 21 ist schematisch ein Doppelpfeil in der Darstellung der Fig. 2 eingezeichnet, um zu verdeutlichen, daß durch den Autofokusstrahlengang 21 sowohl eine Einstrahlung von Autofokus-Beleuchtung also auch eine Autofokus-Detektion erfolgt. Der Strahlteiler 22 ist deshalb für den Wellenlängenbereich der Autofokus-Beleuchtung und der entsprechenden Detektion reflektiv, beispielsweise für Strahlungen oberhalb 800 nm. Für den Wellenlängenbereich der Bearbeitungslaserstrahlung, z. B. 780 nm, ist der Strahlteiler 22 hingegen vorzugsweise transparent; er ist dann als Dichroit ausgebildet.

Je nach chromatischer Korrektur fokussiert das Objektiv 20 die Autofokus-Strahlung, die in der Schemadarstellung der Fig. 2 gestrichelt gezeichnet ist, in eine etwas andere Tiefe, als die Bearbeitungslaserstrahlung 14, welche mit durchgezogenen Linien eingetragen ist.

Die bereits erwähnte Kamera 16 dient zur Beobachtung des Werkstückes 2 im Durchlichtbetrieb. Dazu wird Durchlichtstrahlung 23 mittels eines Kondensors 24 auf der dem Objektiv 20 gegenüberliegenden Seite in das Werkstück 2 geleitet, wobei die Durchlichtstrahlung in einem Spektralbereich liegt, den die Strahlteiler 19 und 22 zumindest teilweise transmittieren. Mittels einer Tubuslinse 25 und dem Objektiv 20 erfolgt dann eine Abbildung des Werkstückes 2 im Durchlichtbetrieb auf die Kamera 16. Der Tubuslinse 25 ist in einer Ausführungsform ein Filter 26 vorgeordnet, das dafür sorgt, daß vorwiegend Durchlichtbeleuchtung, z. B. bei 580 nm, auf die Kamera 16 gelangt. Das Filter 26 kann beispielsweise als Kurzpaßfilter mit einer Filterkante von 750 nm ausgebildet sein.

Die Kamera 16 bildet somit das Werkstück 2 im Durchlichtbetrieb oder, wenn eine Fluoreszenz im Werkstück 2 auftritt, auch im Fluoreszenzstrahlungsbetrieb ab. Ein hier für die Kamera möglicher Wellenbereich liegt im Bereich von 400-600 nm.

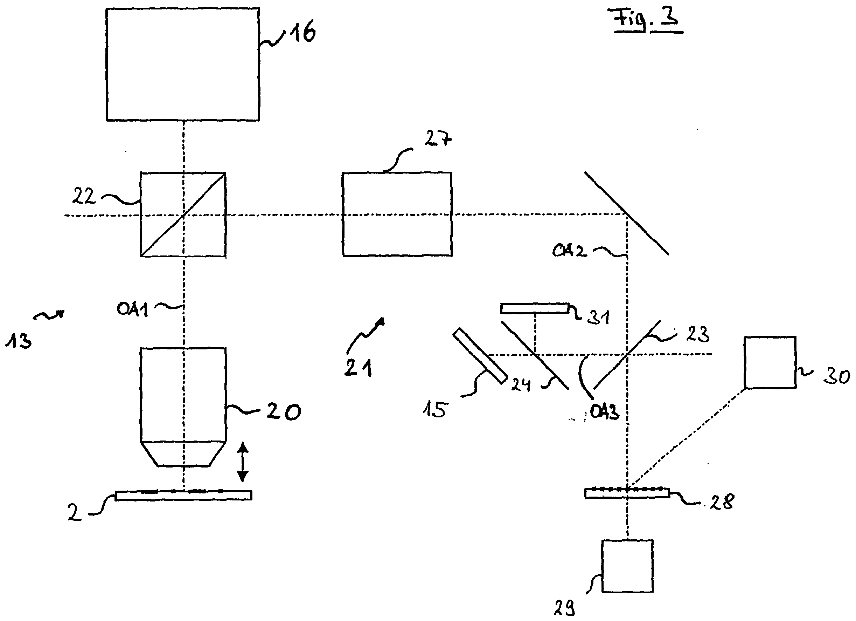

Fig. 3 zeigt den Mikroskopstrahlengang 13 in Kombination mit einer möglichen Ausführungsform für den Autofokusstrahlengang 21.

Über den Strahlteiler 22 ist auf das Werkstück 2 und durch das Objektiv 20 AutofokusBeleuchtungsstrahlung über eine Beleuchtungs-Tubusoptik 27 eingestrahlt. Der Autofokus-Strahlengang 21 verfügt weiter über einen Lichtmodulator 28, der von einer Lichtquelle 29, für Transmissionsbetrieb oder von einer Lichtquelle 30 für Reflexionsbetrieb beleuchtet ist. Der beleuchtete Lichtmodulator 28 generiert ein leuchtendes Modulationsobjekt. Dieses wird über die Beleuchtungs-Tubusoptik 27, den Strahlteiler 22 sowie das Objektiv 20 in das Werkstück 2 projiziert, also abgebildet. Dadurch ist eine Autofokus-Beleuchtung realisiert. Das im Werkstück 2 erzeugte Bild des Modulationsobjektes wird im gegenläufigen Weg mittels des Autofokusdetektors erfaßt, der z. B. als 2D-Kamera 15 ausgebildet sein kann und dem ein weiterer Strahlteiler 15 auf der optischen Achse OA2 der Autofokuseinrichtung vorgelagert ist. Die dabei entlang der optischen Achse OA3 propagierende Strahlung ist optional weiter noch über einen Strahlteiler 24 auf eine weitere Kamera 31 geleitet.

Der Strahlteiler 22 ist, wie erwähnt, in einer Bauweise dichroitisch ausgebildet und die Lichtquelle 29 bzw. 30 strahlt bei z. B. einer Wellenlänge, die im Mikroskop ansonsten nicht benötigt wird. Die Autofokuseinrichtung arbeitet somit in einem Spektralbereich, der für die Abbildung oder Bearbeitung des Werkstückes 2 nicht verwendet ist.

Von den Kameras und Detektoren sind in den Figuren meist nur die Bildebenen gezeichnet. Die Kameras können generell CCD-Kameras sein, die Lichtquellen LED.

In der Bauweise der Fig. 3 liegt der Lichtmodulator 28 und damit das Modulationsobjekt senkrecht zur optischen Achse OA2. Die Kamera 15 steht mit ihrer Bildebene dagegen schräg zur optischen Achse. Nimmt der Lichtmodulator 28 beispielsweise eine räumliche Modulation vor, z. B. ein Streifenmuster, findet sich der maximale Kontrast in einer senkrecht zur Zeichenebene liegenden Zeile der Kamera 15. Die Lage dieser Zeile längs der Kamera 15 ist ein Maß für die Lage der Fokusebene längs der optischen Achse, d. h. in z-Richtung.

Mit Hilfe der Beleuchtungs-Tubusoptik 27 und des Objektivs 20 wird das Modulationsobjekt, das vom Lichtmodulator 28 entweder in Transmissionsbetrieb (Lichtquelle 29) oder im Reflexionsbetrieb (Lichtquelle 30) erzeugt wird, in das Werkstück 2 abgebildet. Durch die schräggestellte Kamera 15 erfolgt eine Tiefenauflösung. Mittels der Kamera 31 kann zusätzlich eine laterale Verschiebung der strukturiert beleuchteten Probe detektiert werden.

Das Mikroskop 1 ist ohne weitere Einschränkung hinsichtlich der Autofokuseinrichtung zur Bearbeitung als scannendes Mikroskop ausgebildet. Auch kann eine inverse Bauweise, wie in Fig. 2, oder eine aufrechte Bauweise, wie in Fig. 3, gleichermaßen verwendet werden.

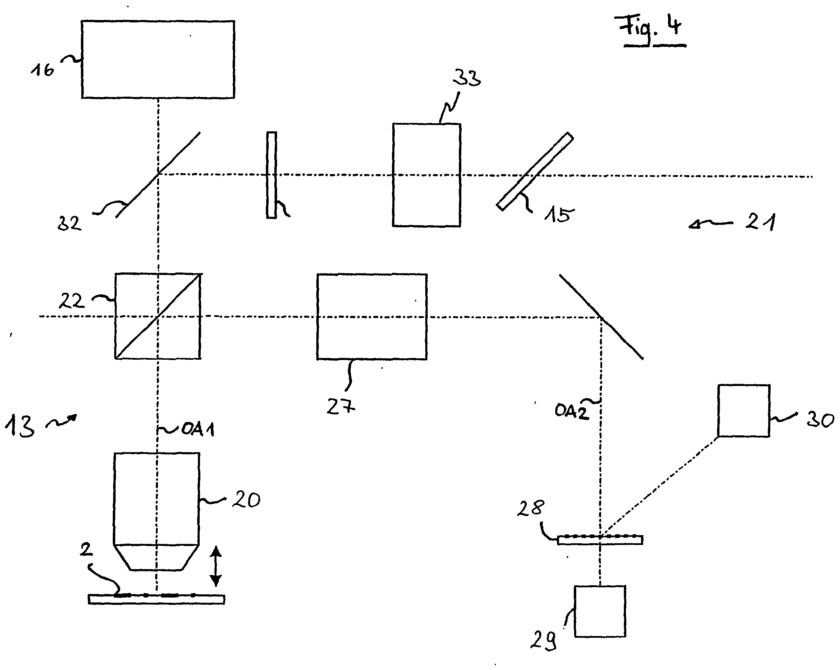

Fig. 4 zeigt eine alternative Gestaltung des Mikroskops der Fig. 1 hinsichtlich der Autofokuseinrichtung. Im Mikroskop der Fig. 4 sind Bauteile, die bereits zuvor erläutert wurden, mit denselben Bezugszeichen versehen; auf ihre wiederholte Beschreibung wird deshalb verzichtet. Die Kamera 15 detektiert hier das Bild der strukturierten Autofokus-Beleuchtung durch einen eigenständigen Detektionsstrahlengang.

Dazu ist im Mikroskopstrahlengang 13 ein eigenständiger Strahlteiler 32 vorgesehen. Dieser ist an die Wellenlänge der Autofokus-Beleuchtung angepaßt und z. B. im gleichen Maße dichroitisch, wie der Strahlteiler 22. Um das in die Probe abgebildete Modulationsobjekt bzw. dadurch erzeugte Reflexe oder Rückstreuungen mittels der Kamera 15 erfassen zu können, ist der Kamera 15 hier eine entsprechende Relaisoptik 23 vorgeordnet, deren optische Charakteristik dafür sorgt, daß die Bildebene der Kamera 15 eine konjugierte Ebene zum Modulationsobjekt schneidet, idealerweise nahe oder auf der optischen Achse (wie bei Fig. 3 auch).

Die von der Autofokuseinrichtung, insbesondere der Kamera 15 gelieferten Signale werden zur Ansteuerung einer Fokusverstellung längs der z-Achse verwertet. Da ist in Fig. 4 schematisch durch einen Doppelpfeil veranschaulicht. Die dazu eingesetzte Steuereinheit ist in Fig. 1 mit 17 bezeichnet.

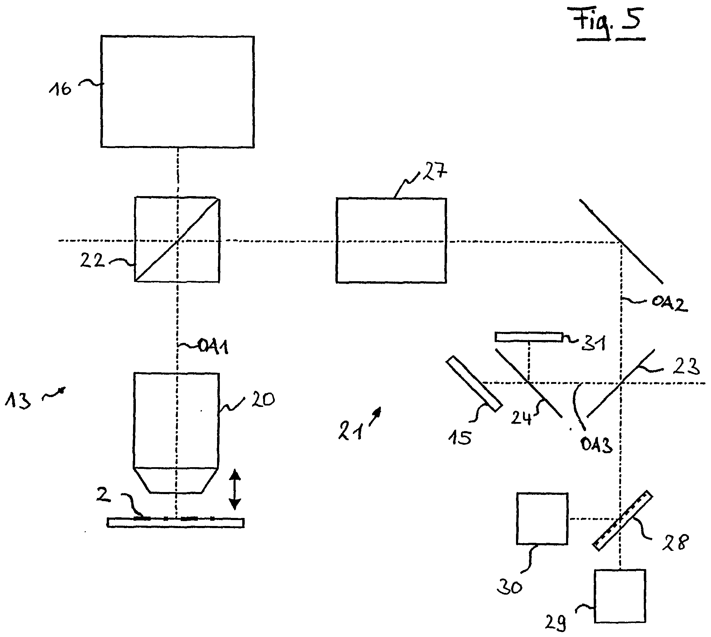

Fig. 5 zeigt eine Ausbildung des Mikroskops 1 für stark streuende und wenig reflektierende Proben. Elemente, die bereits zuvor erläutert wurden, werden nicht weiter beschrieben. Sie sind in der Figur mit den gleichen Bezugszeichen versehen.

Für stark lichtstreuende Oberflächen ist die Autofokuseinrichtung gemäß Fig. 5 abgewandelt. Es handelt sich um eine Einrichtung, die vorwiegend das von der Probe gestreute Licht analysiert.

Bei dieser Anordnung schließt der zweidimensionale Lichtmodulator 28 mit der optischen Achse OA2 einen Winkel zwischen 0° und 90°, bevorzugt zwischen 20° und 70° ein. Der Lichtmodulator 28 entspricht wieder der bereits geschilderten Bauweise, d. h. es kann sich um ein Transmissions-LCD, ein Reflexions-LCD, ein DMD oder ein Amplitudengitter mit Verschiebevorrichtung handeln. Die Struktur besteht vorzugsweise wiederum aus Hell-Dunkel-Streifen. Die Beleuchtung des Lichtmodulators 28 erfolgt vorzugsweise durch eine oder mehrere leistungsstarke LED. Auch dies war bei den schon geschilderten Varianten möglich. Bei einem Transmissionsmodulator ist die Lichtquelle 29 vorgesehen, bei einem Reflexionsmodulator die Lichtquelle 30. Übliche optische Vorrichtungen zur Lichthomogenisierungen und Optiken zu Zwischenabbildungen können zur Erzeugung des Modulationsobjektes mit dem Lichtmodulator 28verwendet werden und sind aus Gründen der Übersicht in der Fig. 5 (wie auch in den vorherigen Figuren) nicht dargestellt.

Mit Hilfe der Beleuchtungs-Tubusoptik 27 und des Objektivs 20 wird das Modulationsobjekt in das Werkstück 2 abgebildet. Da der Lichtmodulator 28 und damit das Modulationsobjekt nicht senkrecht zur optischen Achse steht, wird das Modulationsobjekt (z. B. alternierende Hell-Dunkel-Streifen) schräg zur optischen Achse und damit in die Tiefe des Werkstückes abgebildet.

Die Bildebene der Kamera 15 liegt in einer zum Lichtmodulator 28 und damit zum Modulationsobjekt konjugierten Ebene. Sie ist also im gleichen Winkel zur optischen Achse (hier die optische Achse OA3) verkippt, wie der Lichtmodulator 28. Hierdurch wird von der Probe gestreutes Licht moduliert auf die Kamera 15 abgebildet. Der Kontrast des Modulationsobjektes erscheint auf Kamera 15 nur dort, wo er vom Werkstück gestreut wird. Daher ist die Ausführung in Fig. 5 besonders für dünne oder streuende Werkstücke geeignet.

Zusätzlich weist die Autofokuseinrichtung für die Autofokusfunktion noch die Kamera 31 auf, deren Bildebene gegenüber dem Lichtmodulator 28 und damit dem Modulationsobjekt schräg steht, da sie senkrecht zur optischen Achse OA3 liegt. Sie ist über einen 50 %-Splitter 24 innerhalb des Autofokusstrahlenganges 21 eingespiegelt.

Eine weitere Abwandlung der Autofokuseinrichtung ist dahingehend möglich, daß die Kamera 15 nun gegensinnig zum Lichtmodulator 28 verkippt ist. Die Bildebene der Kamera 15 und der Lichtmodulator 28 sind dann nicht konjugiert zueinander. Hierdurch kann der Fangbereich vergrößert, typischerweise verdoppelt werden.

Die Bauweisen der Fig. 3 bis 5 zeigen die Anordnung der Autofokuseinrichtung bei einem aufrechten Mikroskop 1. Zwischen Objektträger und Objektiv kann sich ein Deckglas wie auch eine Immersionsflüssigkeit (z. B. Öl, Wasser, Glycerin) befinden. Dies ist aber nicht zwingend erforderlich. Es gibt also zwei zu unterscheidende Anwendungsfälle: Ohne Immersionsflüssigkeit erhält man den höchsten Kontrast von der Luft/Glas-Grenzfläche an der Deckglas- oder Objektträgeroberseite. Mit Immersionsflüssigkeit erhält man den höchsten Kontrast von der Grenzfläche zwischen Deckglas-Unterseite und Einbettmedium. Zur Unterdrückung von Streulicht oder unerwünschten Reflexen können Blenden, z.B. halbkreisförmige Blenden, in den Autofokus-Strahlengang eingebracht werden.

Der Strahlteiler 22 kann eine planparallele Glasplatte sein, die auf einer Seite entspiegelt ist, um störende Sekundärbilder zu vermeiden. Die der Reflexion des Autofokussignals dienende Seite der Glasplatte kann auch eine dichroitische Beschichtung aufweisen, die die Reflektivität für das langwellige Autofokuslicht erhöht (wenn die Variante mit langwelliger Autofokusbeleuchtung verwendet wird) und das kurzwelligere Nutzlicht der Bearbeitungsstrahlung überwiegend transmittieren. Natürlich sind auch andere spektrale Aufteilungen möglich.

Zur Erzielung einer hohen Auflösung, wie sie beim direkten Laserschreiben üblicherweise erforderlich ist, wird mit Immersionsflüssigkeit gearbeitet, so daß ein Brechzahlsprung an der Grenzfläche zwischen Deckglas und Werkstück 2 bzw. dessen polymerer Resist-Schicht vorliegt. Die beschriebenen Mikroskoptypen mit eigenständiger Autofokusanordnung erlauben es, die Lage dieser Grenzfläche während des direkten Laserschreibens zu bestimmen, soweit sichergestellt ist, daß die für den Autofokus verwendete Wellenlänge keine unerwünschte Bearbeitungswirkung am Werkstück 2 hat, beispielsweise einen Photo-Resist nicht belichtet.

Entscheidend für den Einsatz des Autofokus ist eine genau Kalibrierung der Grenzflächenposition mit einer der Auflösung des Autofokus angepaßten Genauigkeit. Für ein dem direkten Laserschreiben vorgeschaltetes Kalibrierungsverfahren wird ein Referenzobjekt verwendet, das vorzugsweise mit einem Deckglas abgedeckt ist, welches wegen der zwar nur geringen aber dennoch vorhandenen Brechzahldifferenz zum Immersionsöl vorzugsweise in etwa genauso dick ist, wie das des Werkstücks 2. Eine einfache und genau zu vermessende Referenzprobe besteht aus einer geeigneten Farbstofflösung (z. B. Fluorescein) mit Deckglasabdeckung. Diese Farbstofflösung hat (wie andere Lösungen auch) als Referenzprobe den Vorteil, daß im Fokus der Bearbeitungsstrahlung photochemisch zerstörte Farbstoffmoleküle automatisch durch Diffusion ersetzt werden. Eine Alternative für eine flüssige Farbstofflösung als Referenzprobe ist es, einen Farbstoff in einem Photo-Resist zu lösen und mit dem Resist auf ein Deckglas aufzuschleudern.

Der Farbstoff ermöglicht vorzugsweise eine Fluoreszenzanregung durch Zwei-Photonen-Absorption bei der Wellenlänge der Bearbeitungsstrahlung z. B. 780 nm.

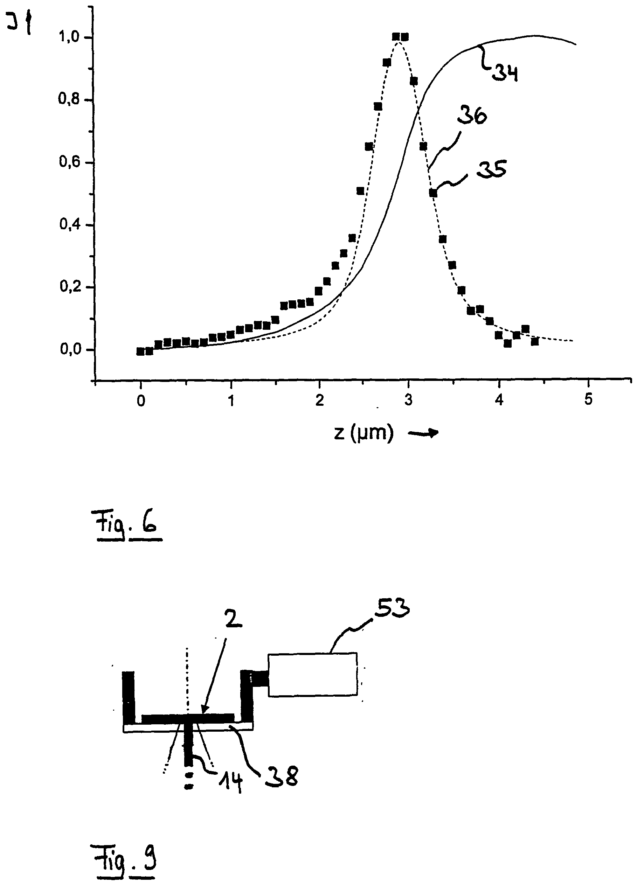

Die Kalibrierung erfolgt nun so, daß mit der Kamera 16 eine Serie von Bildern mit schrittweiser Fokussierung der Bearbeitungslaserstrahlung 14 in der Nähe der Grenzfläche aus dem Deckglas in das Medium mit dem Farbstoff hinein aufgenommen wird. Die beschriebenen, der Kamera 16 vorgeordneten Filter bewirken, daß diese nur Licht unterhalb der Bearbeitungslaserstrahlung, die hier als Anregungslaserstrahlung fungiert, aufnimmt. Aus dieser Serie von Bildern, wird die Ebene der Grenzfläche zwischen Deckglas und Fluoreszenzlösung ermittelt, wobei zur Erhöhung der Meßgenauigkeit optional das mit der Kamera 16 aufgenommene Signal noch um eine geeignete Bildregion um den Fokusspot herum gemittelt werden kann. Die Darstellung des derart erhaltenen Signals als Funktion der z-Koordinate, die sich längs der optischen Achse OA1 erstreckt, ist in Fig. 6 dargestellt. Diese zeigt auf der Hochachse die Intensität I des Signals in willkürlichen Einheiten, und auf der Querachse ist die axiale Koordinate z in Mikrometern aufgetragen. Kurve 34 ist das Intensitätssignal als Funktion der z-Koordinate. Die Meßpunkte 36 sind aus der Ableitung der Kurve 34 bzw. der diese erzeugenden Meßpunkte erhalten. Eine Interpolation 36 erhöht die Genauigkeit auch bei Abweichungen, die in den Meßpunkten 35 vorliegen können. Die Lage des Maximums der Interpolation 36 bzw. der Meßpunkte 35 gibt präzise die z-Koordinate der Grenzfläche zwischen Deckglas und Probe wieder. Diese z-Position wird nun mit der entsprechenden Angabe der Autofokuseinrichtung verglichen und als Referenzpunkt festgelegt.

Um Abweichungen durch Abberrationen zu vermeiden, sollte beim beschriebenen Kalibriervorgang, der Fokus der Autofokusbeleuchtungsstrahlung möglichst mit dem Fokus der Bearbeitungslaserstrahlung 14 zusammenfallen und gegebenenfalls die chromatische Korrektur so ausgelegt sein, daß der Fokus der Autofokusbeleuchtungsstrahlung eher etwas im Deckglas oder im Immersionsmedium liegt, wenn die Bearbeitungslaserstrahlung 14 exakt auf die Grenzfläche fokussiert ist.

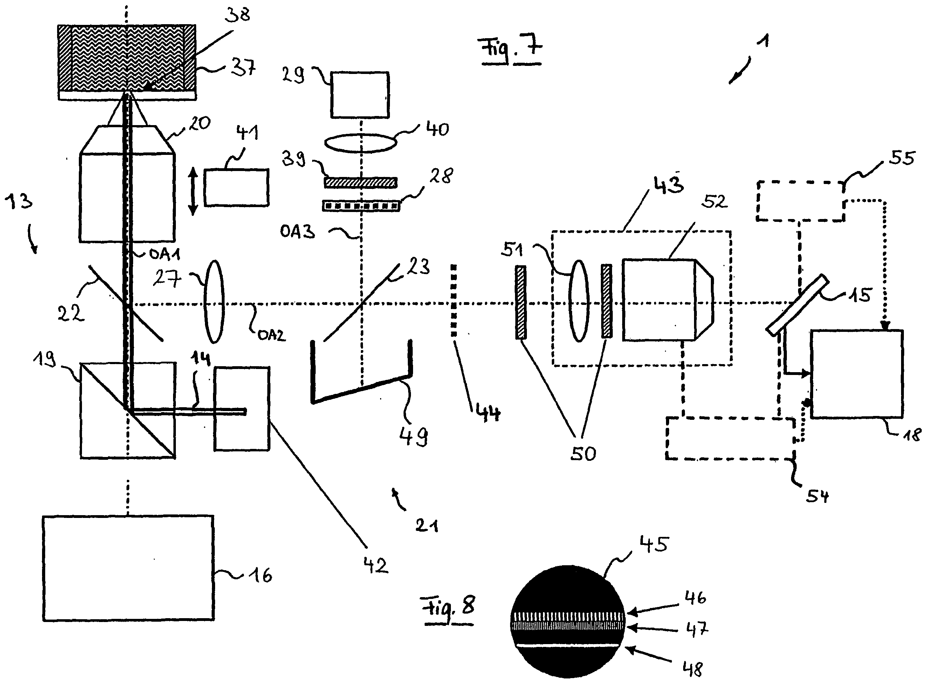

Fig. 7 zeigt ein inverses Mikroskop 1 mit einer Autofokuseinrichtung, das im Zustand der eben erläuterten Kalibrierung ist. Anstelle des Werkstückes ist deshalb eine nach oben geöffnete Küvette 37 mit Farbstofflösung verwendet, die gegenüber dem Immersionsmikroskop mit dem erwähnten Deckglas 38 abgeschlossen ist.

Der Strahlengang 21 der Autofokuseinrichtung ist in der Bauweise der Fig. 7 wiederum über einen Strahlteiler 22 in den Mikroskopstrahlengang 13 eingekoppelt. Ansonsten gilt das bereits Gesagte analog. Zusätzlich ist in Fig. 7 noch ein optionales Spektralfilter 39 eingezeichnet, das den Spektralbereich der Autofokusbeleuchtungsstrahlung geeignet filtert. Auch ist eine Ausleuchtungsoptik 40 zur Erzeugung des Modulationsobjektes aus dem Lichtmodulator 28 exemplarisch dargestellt. Zur homogenen Ausleuchtung des Lichtmodulators 28 enthält vorzugsweise die Ausleuchtungsoptik 40 auch eine Streuscheibe. Eine Ausleuchtungsoptik 40 kann in allen beschriebenen Varianten verwendet werden.

Weiter zeigt Fig. 7, daß die Signale der Kamera 15 an eine Steuereinheit 18 geleitet werden, die entsprechende Berechnungen vornimmt und unter anderem den bereits erwähnten Antrieb 41 zur z-Verstellung der Fokuslage ansteuert. Natürlich ist die Steuereinheit 18 in der Regel auch mit dem Lichtmodulator 28 verbunden, sofern dieser ansteuerbar ist. Gleiches gilt für die Lichtquelle 39 oder 30 und eine Strahlungsquelle 42 der Bearbeitungslaserstrahlung. Die Steuereinheit ist entweder mit der Mikroskopsteuereinheit 17 verbunden, oder in diese integriert.

Im Autofokusstrahlengang 21 ist der Kamera 15 eine Abbildungsoptik 43 vorgeordnet, so daß nicht das Bild des Modulationsobjektes direkt, sondern ein Zwischenbild 44 auf die Kamera 15 abgebildet wird. Natürlich kann dieses Prinzip, das in Fig. 7 am Beispiel eines inversen Mikroskops gezeigt ist, ganz grundsätzlich Anwendung finden. Der hier als Transmissionsgitter ausgebildete Lichtmodulator 28 und das Zwischenbild 30 liegen in Ebenen, die zur Fokusebene im Werkstück sowie zu der Ebene, welche die Kamera 15 schneidet, konjugiert sind.

Die Abbildung des im Werkstück bzw. dem Referenzobjekt liegenden Bildes des Modulationsobjektes unter Verwendung des Zwischenbildes 30 hat den erheblichen Vorteil, das der Autofokus (AF)-Strahlteiler 23, der z. B. als 50:50-Strahlteiler abgebildet sein kann, in großer Entfernung zur Kamera 15 liegt. Unvermeidbares Streulicht vom AF-Strahlteiler 23 gelangt so nur noch über Mehrfachreflexionen, d. h. stark abgeschwächt zur Kamera 15. Zusätzlich werden durch die Zwischenbildeinkopplung auch alle von Optiken rechts des AF-Strahlteilers 23 stammenden Reflexe zur Kamera 15 hin vermieden.

In einer exemplarischen Bauweise der Autofokuseinrichtung für das Mikroskop 1 der Fig. 7 wird als Lichtquelle 29 eine IR-LED verwendet, deren Schwerpunktwellenlänge oberhalb 800 nm liegt, vorzugsweise bei 830 nm. Die Lichtquelle 29 ist mit dem Steuergerät 18 verbunden, so daß sie Bedarf ein- oder ausgeschaltet, zeitlich moduliert oder in ihrer Helligkeit regulierbar wird.

Der Lichtmodulator 28 ist als spaltenförmiges Transmissionsgitter ausgebildet. Um die Spalten möglichst homogen auszuleuchten und die Strahlung der Beleuchtungsquelle 29 somit möglichst effizient zu nutzen, ist die Ausleuchtungsoptik 40 z. B. als Kollimatoroptik mit einer anamorphotischen Optik vorgesehen, die eine linienförmige Beleuchtung bewirkt. Dem Lichtmodulator 28 optimal vorgeordnet (alternativ auch nachgeordnet) ist das Filter 39, das z. B. als IR-Bandpaßfilter ausgebildet und an die Schwerpunktwellenlänge der IR-LED angepaßt ist. Die Bandpaßbreite liegt zwischen 10 und 50 nm, wodurch unerwünschte spektrale Anteile der Lichtquelle 29 unterdrückt werden.

Ein Beispiel für einen Lichtmodulator 28 ist ein Transmissionsgitter 45, wie es exemplarisch in Fig. 8 in Draufsicht gezeigt ist. Es besteht aus einer spaltförmige Blende, die eine periodische Gitterstruktur 46 enthält. Dieser Gitterspalt befindet sich in der Bildmitte oder in der Nähe der Bildmitte, um eine möglichst großen Fangbereich der Autofokuseinrichtung zu gewährleisten. Optional können, wie in Fig. 8 zu sehen ist, weitere Gitterspalte 47 mit anderen Gitterperioden vorgesehen sein, um durch Auswahl der Gitterperiode den Abbildungskontrast auf der Kamera zu optimieren. Die Auswahl geschieht vorzugsweise durch entsprechendes Auslesen der 2D-Kamera 15. Auch kann ein schmaler Spalt 48 ohne Gitterstruktur vorgesehen sein. Das von der Glas/Flüssigkeits-Grenzfläche reflektierte Licht des Spaltbildes gelangt auf einen separat auslesbaren Anteil der Kamera 15. Damit kann außerhalb des eigentlichen Fangbereichs anhand der abgebildeten Helligkeitsverteilung über den Spalt die Defokussierung grob ermittelt werden. Somit ist eine Vorfokussierung möglich, auch wenn noch kein Kontrastsignal vom Gitter an der Kamera 15 vorliegt. Damit kann das Steuergerät 18 ermitteln, in welche Richtung die z-Verstellung erfolgen muß, d. h. wie der Antrieb 41 anzusteuern ist, um wieder in den primären Fangbereich zu gelangen. Ist der Spalt hinreichend schmal, so ist die Helligkeit aufgrund konfokaler Unterdrückung an der Kamera 15 höher. Aus der Steigung der Helligkeitsverteilung kann der notwendige Verfahrweg in den primären Fangbereich abgeleitet werden. Dies führt das Steuergerät 18 durch.

Am AF-Strahlteiler 23 ist eine Lichtfalle 49 vorgesehen, die Strahlung vom Lichtmodulator 28, welche transmittiert würde, absorbiert. Die Lichtfalle 49 ist vorzugsweise als schräg zur optischen Achse gestellte Platte eines stark absorbierenden Materials ausgebildet, z. B. als polierte NG1-Platte. NG1 ist ein stark absorbierendes, schwarzes Glas.

Der dichroitische Strahlteiler 22 reflektiert nur Strahlung der Wellenlänge, wie sie nach dem Bandpaßfilter 39 im Autofokusstrahlengang 21 geführt ist. Andere Spektralanteile werden transmittiert. Dazu weist der Strahlteiler 22 z. B. eine Interferenzschicht auf, die Strahlung unterhalb 800 nm bei einem Einfallswinkel von 45° weitgehend transmittiert und Strahlung mit der Schwerpunktwellenlänge der IR-LED weitgehend reflektiert. Auch kann der Strahlteiler 22 ein bandpaßartiges Spektralverhalten aufweisen, so daß Wellenlängen oberhalb des Autofokus-Spektralbereiches (z. B. oberhalb 840 nm) ebenfalls bei 45° Einfallswinkel weitgehend transmittiert werden. Natürlich können diese Strahlteilermerkmale auch in anderen Ausführungsformen verwendet werden.

Weiter ist es vorzugsweise möglich, den Strahlteiler wechselbar zu gestalten, z. B. mittels eines Wechselrades oder eines anderen Wechselmechanismus.

Der Abbildung des in der Probe liegenden Bildes des Modulationsobjektes bzw. dessen Zwischenbild 30 sind optional Sperrfilter 50 vorgelagert, die dafür sorgen, daß nur Strahlung des entsprechenden Autofokus-Spektralbereiches zur Kamera 15 gelangt. Andere Strahlung, die aus der Abbildung der Probe stammen kann, wird dadurch nochmals unterdrückt.

Die Abbildungsoptik 43 bildet das im Werkstück bzw. dem Referenzobjekt liegende Bild des Modulationsobjektes bzw. das an der Grenzfläche reflektierte Bild auf die Kamera 15 ab. Die Abbildungsoptik 43 kann z. B. aus einer Tubuslinse 51 und einem Standardobjektiv 52 mit kleiner numerischer Apertur (z. B. NA=0,2) aufgebaut sein.

Fig. 9 zeigt die Abwandlung des Aufbaus der Fig. 7, wie sie im Falle des direkten Laserschreibens an einem Werkstück 2 vorliegt. Anstelle der Küvette 37 befindet sich nun das Werkstück 2 mit dem bezogen auf die Strahleinfallsrichtung darüber liegenden Deckglas 38. Weiter ist noch ein Scanaktor 23 eingezeichnet, der die bereits zuvor erwähnte (x,y,z)-Verstellung des Werkstücks 2 zum Erzeugen einer dreidimensionalen Struktur mittels direktem Laserschreiben vornimmt. Natürlich ist der Scanaktor 23 über (nicht dargestellte) Leitungen mit der Mikroskopsteuereinheit 18 verbunden, die den gesamten Betrieb des Gerätes steuert.

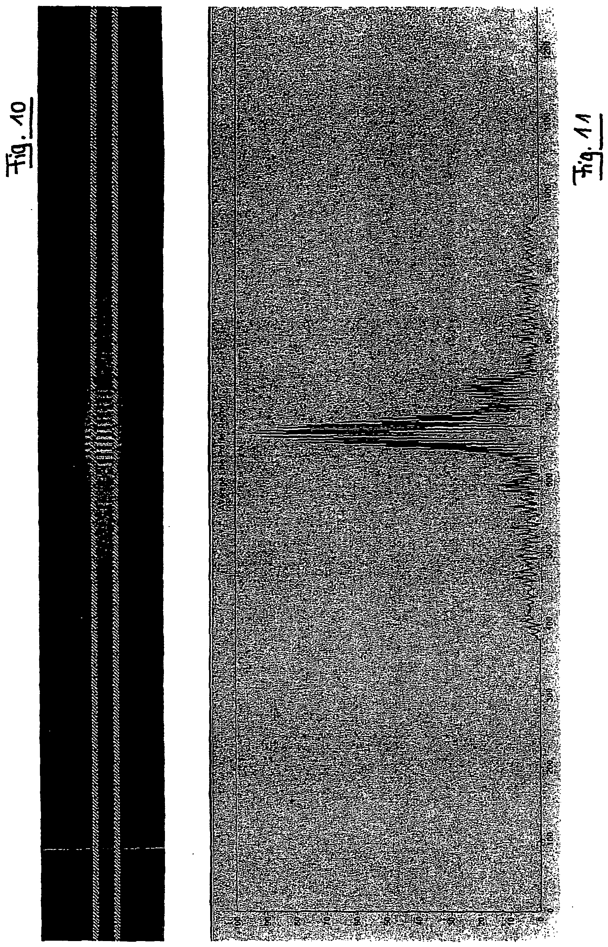

Die Fig. 10 und 11 zeigen das Kontrastsignal der Kamera 15 beim Autofokussystem, z. B. der Bauweise gemäß Fig. 7. Fig. 10 zeigt das Kontrastsignal in Graustufenauftragung in der Kameraebene und Fig. 11 den Betrag der Ableitung des Kontrastsignals. Dabei ist in beiden Figuren eine Auftragung über der Pixelnummer in x-Richtung aufgetragen. Die Ableitung des Kontrastsignals erfolgt zum Zweck der Unterdrückung aller Signalanteile, die nicht den in die Objektebene projizierten Gitterkontrast aufweisen. Alternativ oder ergänzend kann das Kontrastsignal auch einer Fourier-Filterung unterzogen werden, wobei alle nicht zur Gitterperiode korrespondierenden Frequenzen eliminiert werden, um die Signalqualität zu optimieren. Dies entspricht einer Bandpaßfilterung, bei der die Gitterfrequenz in der Mitte des Bandpasses liegt.

Der Fangbereich des Autofokussystems ist vorgegeben durch den Bereich der z-Verschiebung des Objektivs 20 (oder der Grenzfläche), in dem noch ein auswertbares Kontrastsignal auf der Autofokuskamera vorliegt. Zwei Bedingungen müssen hierzu erfüllt sein:
1. Das Kontrastsignal muß sich noch innerhalb des Bildfeldes befinden.
2. Das Kontrastsignal muß einen hinreichenden Signalpegel aufweisen, der signifikant über dem Rauschpegel liegt.

Der Bereich, in dem die Grenzfläche aufgefunden werden kann, ist begrenzt. Für den Fall, daß sich der Kontrastschwerpunkt in der Bildfeldmitte befindet, wenn die Fokusebene des Objektivs 20 genau auf der Grenzfläche liegt, ist der Fangbereich symmetrisch.

Der Autofokus-Kontrast nimmt jedoch bei Verschiebung des Kontrastschwerpunkts von der Bildfeldmitte zum am Bildfeldrand ab. Diese Verschlechterung des Signal/Rausch-Verhältnisses resultiert hauptsächlich aus sphärischer Aberration und aus Koma, zwei Bildfehlern, die zum Bildfeldrand stets zunehmen. Aus diesem Grund sollte die Bildfeldgröße auf der schräg gestellten Autofokuskamera so gewählt werden, daß am Rand des Fangbereichs die Kontrasthöhe gerade noch ausreicht. Die Größe der Kamera ist entsprechend angepaßt.

Um hier eine etwaige störende Beschränkung aufzuheben, ist optional eine Weiterbildung vorgesehen, die exemplarisch in Fig. 7 gestrichelt eingezeichnet ist. Sie weist einen Längs-Verstellmechanismus 54 auf, der den Abstand zwischen Autofokus-Objektiv 52 und Autofokus-Kamera 15 variiert. Dazu kann wahlweise das Objektiv 52 gegenüber der feststehenden Kamera 15 oder die Kamera 15 gegenüber dem feststehenden Objektiv 52 längs der optischen Achse OA2 bewegt werden. Für den vorzugsweise elektronisch angesteuerte Längs-Verstellmechanismus 54 sind alle bekannten Antriebstechniken, wie Spindelantriebe, Schrittmotoren, Gleichstrommotoren, Piezosteller usw. geeignet.

Die Variation des Abstandes zwischen Autofokus-Objektiv 52 und Kamera 15 ist nur ein Beispiel für das allgemein zugrundeliegende Prinzip, der Längsverstellung von Kamera 15 zur Bildebene der Autofokus-Abbildung. Im einfachsten Fall kann der Längs-Verstellmechanismus eine Verschiebung der Kamera 15, der Abbildungsoptik 52 oder des Lichtmodulators 28 bewirken. Die Längs-Verschiebung kann dann trotz Verstellung der Fokusebene immer die Reflexe von der Grenzebene auf die Kamera 15 abbilden, indem die Längsverschiebung gegensinnig erfolgt. Darum wird der Abstand zwischen Autofokus-Objektiv und Autofokuskamera so angepaßt, daß der Schwerpunkt des Kontrastsignals immer in der Bildfeldmitte liegt. Hierzu werden folgende Schritte durchgeführt:
1. Mit Hilfe des z-Antriebs 41 des Mikroskops wird die Grenzfläche in die Fokusebene des Mikroskop-Objektivs 20 gebracht. Dies ist die Ausgangsposition für den Autofokus. Der Schwerpunkt des Kontrastsignals befindet sich jetzt in der Bildfeldmitte des Autofokus-Objektivs 52, wo die Bildfehler am geringsten sind.
2. Die Fokusebene des Mikroskop-Objektivs 20 wird mit Hilfe des z-Antriebs 41 in das Werkstück bzw. in das Referenzobjekt hinein gefahren. Simultan hierzu wird der Abstand zwischen Autofokus-Objektiv 52 und Kamera 15 so variiert, daß der Kontrastschwerpunkt in der Bildfeldmitte des Autofokus-Objektivs 52 verbleibt.
3. Die gewünschte Fokusebene kann somit ständig zur Grenzfläche referenziert werden. Dadurch werden alle Defokussierungen durch den z-Antrieb 41 ausgeglichen, während der Abstand zwischen Autofokus-Objektiv 52 und Kamera 15 konstant bleibt. Durch die Autofokus-Funktion verbleibt der Kontrastschwerpunkt auch weiterhin in der Bildfeldmitte des Autofokus-Objektivs 52 und damit in der Mitte der Kamera 15.

Begrenzt ist der Fang- bzw. Haltebereich lediglich durch die Bildfehler in der Bildfeldmitte des Autofokus-Objektivs 52. Dabei handelt es sich vorwiegend um sphärische Aberration. Die zum Bildfeldrand hin deutlich zunehmenden Aberrationen, vor allem Koma und Wölbung, wirken sich nun nicht mehr störend aus. Zusätzlich werden noch andere Probleme, die am Bildfeldrand auftreten, wie Randabfall der Beleuchtung, Vignettierung und Reflexe etc. umgangen.

Weil das Kontrastsignal in der Bildfeldmitte verbleibt, kann auch der Lichtmodulator 28 kleiner ausgelegt werden. Es muß nun nicht mehr über das gesamte Bildfeld des Objektivs 20 verlaufen, um den Fangbereich zu maximieren. Dadurch wird weniger Autofokuslicht in den Mikroskopstrahlengang eingekoppelt, was den Streulichtuntergrund auf der Autofokus-Kamera 15 verringert. Wenn ein kleinerer (d.h. kürzerer) Lichtmodulator 28 verwendet wird, kann auch ein kleinerer und damit kostengünstigerer Kamerachip für die Autofokus-Kamera 15 verwendet werden.

Die auf die Kamera 15 abgebildete Struktur des Lichtmodulators 28, dessen Winkel zur Kamera 15, die Auflösung der Kamera 15 u. statistische Intensitätsschwankungen während der Messung beeinflussen die Regelgenauigkeit der z-Position. Um die Regelgenauigkeit z. B. während des Autofokus verändern zu können, durchaus auch abhängig vom Mikroskopobjektiv 20, können optional mehrere als Lichtmodulator 28 nebeneinanderliegende Gitterstrukturen mit unterschiedlichen Perioden ausgewertet werden, wie anhand Fig. 8 bereits erläutert, und/oder der Schrägstellungswinkel des Lichtmodulators 28 oder der Kamera 15 wird einer geforderten Regelgenauigkeit entsprechend angepaßt. Die letztere Option ist in Fig. 7 gestrichelt eingezeichnet. Dort ist ein Winkel-Verstellmechanismus 55 vorgesehen.

Ist der Autofokuseinstellvorgang abgeschlossen, kann z. B. so nach vorher definierten Genauigkeitsanforderungen z.B. der Winkel der Kamera 15 vorzugsweise elektronisch verstellt werden. Die Verstellung des Winkels zwischen Kamera 15 und Bild des Modulationsobjektes erfolgt in einfachsten Fall durch Rotation des Kamera 15 oder des Lichtmodulators 28 mittels eines geeigneten Winkel-Verstellmechanismus.

Hierzu eignen sich alle bekannten Techniken, wie Spindelantriebe, Schrittmotoren, Gleichstrommotoren, Linearmotore, Piezosteller usw. Bei geeignetem Winkel, und entsprechend ausgewähltem Gitter mit geeignetem Gitterabstand, kann die Genauigkeitsauflösung angepaßt werden.

Die geschilderten Verstellmechanismen 54, 55 geben ein Signal ab, das dem Steuergerät 18 der Autofokuseinrichtung zugeführt ist.

Die Autofokusvorrichtung arbeitet also nach folgendem Prinzip: mit einer Lichtquelle, z. B. einer IR-LED mit 840 nm Schwerpunktwellenlänge, wird ein Lichtmodulator streifenförmig moduliertes Transmissionsgitter beleuchtet. Das derart erzeugte leuchtende Modulationsobjekt wird in die Objektebene des Mikroskop-Objektivs 20 projiziert. Wenn sich in der Objektebene oder deren Umgebung eine reflektierende Grenzfläche befindet, wird die Gitterstruktur zurückreflektiert, und diese Reflexe werden auf die 2D-Autofokus-Kamera 15 abgebildet. Da diese gegenüber der optischen Achse der Abbildung verkippt ist, erscheint das Gitter nur in einem schmalen Bereich der Kamerafläche scharf. Zur Eliminierung von Untergrundrauschen kann die Intensitätsverteilung auf der 2D-Autofokus-Kamera 15 zeilenweise differenziert werden.

Anschließend wird für jede Zeile der Kontrastschwerpunkt bestimmt. Zur Verbesserung der Autofokus-Signalqualität werden optional auch die Kontrastschwerpunkte mehrerer Zeilen gemittelt, und die Lage des gemittelten Kontrastschwerpunktes korreliert mit der objektseitigen Lage der reflektierenden Grenzfläche relativ zur Fokusebene des Mikroskop-Objektivs 20 und kann somit als Autofokussignal dienen. Für die besonders hohen Genauigkeitsanforderungen, die üblicherweise beim direkten Laserstrahlschreiben gestellt werden, ist es nötig, daß sich der Kontrastschwerpunkt möglichst in der Nähe der Bildfeldmitte befindet, da auch der Fokus des Bearbeitungslaserstrahls 14 hier ist. Andernfalls könnten Durchbiegungen des Werkstückes 2, beispielsweise einer Glasplatte, auf der sich der Polymer (Resist) befindet, zur Fokusabweichung gegenüber Kalibriermessungen führen.

Der erläuterte Autofokus-Strahlengang 21 der geschilderten Autofokus-Anordnung im Mikroskop 1 kann in vorteilhafter Weise zur Einhaltung von Nah- und Fernordnung einer im Werkstück 2 zu erzeugenden 3D-Struktur beitragen, trotz der Transparenz des Werkstückes 2. Insbesondere kann zu jeder Zeit während des Schreibvorgangs die Grenzfläche zur Referenz verwendet werden. Entweder durch die geschilderte Autofokusfunktion oder durch Anfahren der Grenzfläche, ohne das weitere Annahmen über deren Lage bekannt sein müssen. Somit kann z. B. die aktuelle Lage des Fokus im Werkstück relativ zur Grenzfläche bestimmt werden, indem die z-Position vor und nach dem Anfahren der Grenzfläche ausgelesen wird.

Eine Verkippung der Grenzfläche, also z. B. der Oberfläche des Werkstückes, relativ zur optischen Achse kann vor dem Einsatz der Bearbeitungslaserstrahlung erfaßt und während des direkten Laserschreibens korrigiert werden. Dazu wird die Lage der Grenzfläche des Werkstückes 2 an festgelegten, geeignet ausgewählten Kontrollpunkten abgetastet und es werden die entsprechenden z-Positionen registriert. Bei dieser Vorabtastung kann die Dichte der Kontrollpunkte vom Anwender frei gewählt oder auf Basis einer Programmroutine automatisch von der Mikroskopsteuereinheit 18 festgelegt werden. Die Mikroskopsteuereinheit legt weiter in einem Fit eine ebene Fläche durch die bestimmten z-Positionen der Kontrollpunkte und ermittelt z. B. eine Verkippung der Grenzfläche, also der Oberfläche des Werkstücks 2. Diese Verkippung wird dann beim direkten Laserstrahlschreiben bei der Ansteuerung des Scanaktors 53 berücksichtigt, so daß die am oder im Werkstück 2 mit dem Fokus des Bearbeitungslaserstrahls 14 angefahrenen Punkte trotz einer Verkippung des Werkstücks 2 bzw. dessen Oberfläche an wunschgemäß auf die Oberfläche bezogenen Punkten liegen. Üblicherweise sind solche Punkte im Abstand zur ebenen Oberfläche des Werkstücks 2 angegeben bzw. definiert.

Tritt beim Fitten der z-Positionen der Kontrollpunkte eine zu große Abweichung für einzelne Kontrollpunkte auf, weist dies auf eine Deformation der Grenzfläche hin. Eine solche Abweichung ist immer dann bestimmbar, wenn mehr als drei Kontrollpunkte verwendet werden. Es kann deshalb eine Bearbeitung eines Werkstücks 2 abgelehnt werden, wenn beim Fitten der z-Position der Kontrollpunkte mit einer Ebene einzelne Kontrollpunkte mit ihren z-Positionen um einen Grenzwert von der Ebene beabstandet sind. Alternativ oder zusätzlich kann der z-Abstand, den einzelne Kontrollpunkte von der gefitteten Ebene haben, oder ein aus den Abständen für mehrere Kontrollpunkte berechnetes Maß als Basis für eine Qualitätsangabe über das Werkstück 2 vor oder nach dessen Bearbeitung mit direktem Laserstrahlschreiben herausgezogen werden.

Das direkte Laserstrahlschreiben kann prinzipiell in zwei Strukturierungsarten erfolgen. In einer ersten Variante kann die Strukturierung so erfolgen, daß eine Belichtung bei fixer Lateralposition mit einer Bewegung axialer Richtung erfolgt. Diese Strukturierung wird als sogenannter Axialscan bezeichnet. Nach vollständiger Belichtung über die gewünschte Tiefe des Werkstückes wird der nächste Lateralpunkt angefahren und dann an diesem axial verstellt. Vorzugsweise wird dabei vor dem nächsten axialen Scan nach der Lateralbewegung die Lage des Fokus zur Grenzfläche überprüft.

Alternativ kann die Strukturierung bei gegebener axialer Position durch laterale Verschiebung erfolgen, weshalb dieser Modus auch als Lateralscan bezeichnet wird. Unabhängig von der axialen Position kann hierbei an ausgewählten lateralen Punkten, die mit den erwähnten Kontrollpunkten identisch sein können (aber nicht müssen), die Lage der Grenzfläche bestimmt werden. Vorteilhaft kann hier in jeder Ebene eine neue Referenzierung zur Grenzflächenlage per Fit mit einer ebenen Fläche bestimmt und für den Scan in dieser oder der nächsten Tiefe berücksichtigt werden.

Der beschriebene Aufbau bzw. das beschriebene Verfahren ermöglicht es also, zum einen Verschiebungen während des direkten Laserstrahlschreibens zu kompensieren oder eine Kontrolle der Grenzflächenlage, d. h. der Lage der Oberfläche des Werkstückes vorzunehmen. Auch hierbei kann natürlich bei einer zu starken Ablage ein Abbruch des Schreibvorgangs erfolgen.

Die erfindungsgemäße Vorrichtung kann im Betrieb gesteuert durch die Mikroskopsteuereinheit 18 also folgende Schritte ausführen:
Anhand des beschriebenen Kalibrierlaufs mit einer fluoreszierenden Probe kann eine Kalibrierung des z-Antriebes 41 und (falls vorhanden) des Längsverstellmechanismus sowie gegebenenfalls des (x,y,z)-Aktors erfolgen.

In einem sogenannten Pre-Scan kann die Grenzfläche an verschiedenen Kontrollpunkten mit der Autofokuseinrichtung abgetastet werden, und es werden die z-Positionen der Kontrollpunkte ermittelt. Aus diesen z-Positionen wird eine Ebene modelliert, um die exakte Lage der Grenzfläche zwischen Werkstück 2 und Deckglas, d. h. die Ebene der Oberfläche des Werkstücks 2 zu ermitteln. Liegt für einzelne Kontrollpunkte ein zu großer Abstand von der gefitteten Ebene vor, kann das Werkstück 2 entweder als unzureichend ausgeschieden oder mit einem entsprechenden Qualitätsparameter versehen werden, der auf eine Durchbiegung hinweist. Für eine solche Aktion kann natürlich nicht nur ein einzelner Kontrollpunkt herangezogen werden, sondern auch ein geeignetes Maß, das die z-Abweichungen aller Kontrollpunkte geeignet verknüpft.

Als nächstes wird der Fokus des Bearbeitungslaserstrahls 14 an die Grenzfläche gestellt und der Schreibvorgang begonnen.

Im Falle des Axialscans wird die gewünschte Laserstrahlverstellung in einer Ebene senkrecht zur Grenz-Fläche vorgenommen. Soweit das gesamte dreidimensionale Volumen noch nicht abgearbeitet wurde, erfolgt nach jeder Ebene eine laterale Verstellung, d. h. ein neuer Punkt an der Grenzfläche wird angefahren. Dabei kann optional mittels des Autofokus überprüft werden, ob dieser Punkt auch tatsächlich an der Grenzfläche liegt, nötigenfalls wird eine Korrektur vorgenommen. Diese Korrektur kann auch dadurch erfolgen, indem Bezug auf eine während des Pre-Scans ermittelte Verkippung oder (falls kein Fit mit Ebenen sondern mit Kurven erfolgte) Verwerfung des Werkstückes 2 genommen wird. Für diesen neuen lateralen Punkt erfolgt wiederum ein Scannen senkrecht zur Probenoberfläche/Grenzfläche.; es wird also die nächste Ebene abgearbeitet.

Im Fall eines Lateralscans erfolgt der Schreibvorgang in einer Ebene parallel zur Grenzfläche. Ist diese Ebene abgearbeitet, wird eine neue Axialposition angefahren, für die wiederum unter Bezugnahme auf die vorher bestimmte Grenzfläche eine Ebene modelliert werden kann.

Ist im Axialscan oder im Lateralscan die Probe vollständig bearbeitet, ist der Bearbeitungsprozeß abgeschlossen.

Für alle Ausführungsformen bzw. Betriebsweisen des Mikroskops 1 mit Autofokuseinrichtung gilt folgendes:
Die geschilderten Erweiterungen hinsichtlich Fangbereich bzw. Verstellung der Positioniergenauigkeit lassen sich natürlich nicht nur bei der Bauweise der Fig. 7, sondern bei allen Ausführungsformen einsetzen.

Um bei einem Online-Tracking möglichst geringe Einflüsse durch die strukturierte Beleuchtung, d. h. das Bild des Modulationsobjektes, zu produzieren, kann als Modulationsobjekt ein Streifenmuster auf die Probe projiziert werden, das in schneller Folge (>30 Hz) alternierend lateral verschoben wird. Bei zwei Positionen wäre es eine Phasenverschiebung um 180°, bei drei Positionen eine Phasenverschiebung um 120°. Die Gitterstruktur (Gitterkonstante, Hell/Dunkel-Verhältnis) kann bei Verwendung eines elektronischen Lichtmodulators in der Ansteuerung leicht derart angepaßt werden, daß im zeitlichen Mittel eine homogene Beleuchtung entsteht. Die Anpassung der optimalen Gitterstruktur an das jeweils verwendete Objektiv 20 bzw. dessen NA oder Vergrößerung ist auch möglich.

Ein weiterer Vorteil eines verstellbaren, insbesondere ansteuerbaren Lichtmodulators 28 und damit einer variablen Autofokus-Beleuchtungsstruktur besteht darin, nach dem Auffinden der Grenzfläche nur noch die interessanten Bereiche des Objektfeldes auszuleuchten. Hierdurch kann der Bildkontrast für die Tracking-Vorrichtung, gegebenenfalls aber auch für den normalen Detektionskanal erhöht werden.

Bei allen Varianten des Autofokus- und Tracking-Systems wird eine rechnerische Steuer- und Auswerteeinrichtung (z.B. ein Computer) verwendet, die die Signalanalyse und die Steuerung des Aktuatoren (z-Trieb, (x,y,z)-Tisch, Filter etc.) vornimmt. Auswertung und Steuerung können Firmware- und/oder Software-technisch implementiert werden. Diese Steuer- und Auswerteeinrichtung übernimmt sämtliche hier geschilderte Ablaufsteuerung.

Statt verstellbarer, z. B. elektrisch schaltbarer Lichtmodulatoren (z. B. LCD, DMD) können auch statische Lichtmodulatoren (Transmissions- oder Phasengitter) verwendet werden. Das projizierte Modulationsobjekt kann mit verkippbaren Planplatten oder anderen Vorrichtungen probenseitig verschiebbar sein. Ein Austausch der Gitter kann zur Variation der Gitterkonstante oder -struktur ebenfalls möglich sein. Wie erläutert kann auch eine flächige Gitterstruktur verwendet werden, die mehrere unterschiedliche Gitterperioden aufweist, beispielsweise 2 bis 10 nebeneinander angeordnete Streifengitter mit unterschiedlichen Gitterfrequenzen. Dies zeigt exemplarisch, daß der Lichtmodulator auch linien- bzw. zeilenförmig sein kann und nicht zwingend zweidimensional sein muß.

Da das erfindungsgemäße Autofokusverfahren aber vorzugsweise mit flächigen (zweidimensionalen) Kameras arbeitet, kann eine Rauschunterdrückung durch Auswertung mehrerer Zeilen erfolgen bzw. bei mehreren Gitterzeilen für jeden Anwendungsfall das am besten geeignete Gitter durch Auslesen der entsprechenden Kamerazeilen gewählt werden, ohne mechanische Änderungen (Austausch des Gitters) vornehmen zu müssen. Grundsätzlich sind senkrecht zur optischen Achse stehende Lichtmodulatoren 28 als Transmissionsmodulatoren leichter implementierbar, während geneigte Lichtmodulatoren 28 leichter als Reflexionsmodulatoren realisierbar sind. Sollen sehr kleine Objekte durch das Tracking-System erfaßt werden, so kann es vorkommen, daß eine hinreichend hochfrequente Beleuchtungsmodulation nicht mehr möglich ist. In diesem Fall kann auch räumlich unmoduliert beleuchtet und nur die Intensität der gestreuten oder reflektierten Signale ausgewertet werden. Als ortsauflösende Detektoren kommen neben CCD-Kameras auch CMOS- sowie alle anderen Arten von Digitalkameras in Frage.

Die Autofokuseinrichtung soll einen bestimmten Bereich der Probe automatisch fokussieren oder in der Fokusebene des Objektivs halten. Hierzu kann ein Offset (typisch 0 ... 1000 µm) zwischen Grenzfläche und relevanter Werkstückebene vorgegeben werden. Wird dieser Offset in Stufen variiert, so wird das Werkstück, wie erläutert, dreidimensional, in stets definiertem und kontrolliertem Abstand zur Grenzfläche bearbeitet.

Soweit in dieser Beschreibung Verfahrensschritte bzw. besondere Betriebsweisen oder -Modi geschildert sind, werden diese durch ein zur Autofokuseinrichtung gehörenden Steuereinrichtung z. B. wie im Steuergerät 18, realisiert.

Um mit der Autofokuseinrichtung möglichst weit in die Probe hinein messen zu können, kann die Kamera 15 asymmetrisch zur jeweiligen optischen Achse, (z. B. optischen Achse OA2 in Fig. 7) angeordnet sein, so daß sich ein asymmetrischer Fangbereich ergibt. Beispielsweise kann das Kontrastmaximum von Anfang an nahe einem Rand des Fangbereiches liegen, wenn eine Grenzfläche mit der eingestellten Fokusebene des Objektivs 20 zusammenfällt. Der andere Rand des Fangbereichs entspricht dann dem maximalen Abstand von der Grenzfläche zur eingestellten Fokusebene, in dem noch der Fokus fixiert werden kann, also dem maximalen Haltebereich.

Je nach Objektiwergrößerungen sind Fang- bzw. Haltebereiche von 10 µm bis 10mm erreichbar. Die Auflösung in z-Ebene beträgt je nach Objektiwergrößerung numerischer Apertur 5 nm bis 5 µm. Die z-Auflösung ist also stets mindestens 5-mal besser als die Schärfentiefe des verwendeten Objektivs 20.

## Patentansprüche

1. Verfahren zur Laserstrahlbearbeitung eines Werkstückes (2), wobei ein Laserstrahl (14) durch ein Objektiv (20), das eine Fokusebene aufweist, in oder auf das eine Grenzfläche aufweisende Werkstück (2) zum Erzeugen eines Bearbeitungseffektes mittels Zwei-Photonen-Prozessen in einem Fokus gebündelt wird und die Lage des Fokus gegenüber dem Werkstück (2) verstellt wird, **dadurch gekennzeichnet, dass** zur Referenzierung der Lage des Fokus ebenfalls durch das Objektiv (20) ein leuchtendes Modulationsobjekt auf das Werkstück (2) in die Fokusebene oder diese schneidend abgebildet wird, an der Grenzfläche auftretende Reflexe der Abbildung in eine Autofokus-Bildebene abgebildet werden, und mit einer eine Kamera-Bildebene aufweisenden Kamera (15) detektiert werden, wobei die Kamera-Bildebene entweder die Autofokus-Bildebene schneidet, wenn das Bild des leuchtenden Modulationsobjektes in der Fokusebene liegt, oder in der Autofokus-Bildebene liegt, wenn das Bild des Modulationsobjektes die Fokusebene schneidet.

2. Verfahren nach Anspruch 1, **dadurch gekennzeichnet, daß** über das Werkstück (2) ein Deckglas (38) gelegt wird und der Übergang Werkstück/Deckglas als Grenzfläche dient.

3. Verfahren nach Anspruch 1 oder 2, **dadurch gekennzeichnet, daß** das Modulationsobjekt (28) in einem Spektralbereich leuchtet, der von dem des Laserstrahls (14) verschieden ist, und daß der Spektralbereich des Laserstrahls (14) bei der Detektion mit der Kamera (15) ausgefiltert wird.

4. Verfahren nach einem der obigen Ansprüche, **dadurch gekennzeichnet, daß** während der Laserstrahlbearbeitung zumindest intermittierend die Lage der Grenzfläche bestimmt und als Referenz für die Einstellung der Lage des Fokus verwendet wird.

5. Verfahren nach einem der obigen Ansprüche, **dadurch gekennzeichnet, daß** vor der Laserstrahlbearbeitung die Lage der Grenzfläche an verschiedenen lateralen Punkten bestimmt und durch eine Ebene modelliert wird, um die Lage der Grenzfläche genauer zu bestimmen.

6. Verfahren nach Anspruch 5, **dadurch gekennzeichnet, daß** aus Abständen der Lage der lateralen Punkte von der modellierten Ebene ein Maß über eine Abweichung der Grenzfläche von einer idealen Ebene ermittelt wird und dem Werkstück ein Qualitätsparameter zugeordnet wird, der auf dem Maß basiert, wobei insbesondere bei Vorliegen eines bestimmten Qualitätsparameterbereichs eine weitere Bearbeitung des Werkstücks unterbunden wird.

7. Verfahren nach einem der obigen Ansprüche, **dadurch gekennzeichnet, daß** das Werkstück (2) bearbeitet wird, indem die Lage des Fokus dreidimensional verstellt wird, wobei der Fokus in Ebenen verstellt wird, die nacheinander jeweils vollständig abgearbeitet werden und die entweder parallel oder senkrecht zur Grenzfläche liegen, wobei für jede Ebene jeweils eine Referenzierung auf die Grenzfläche erfolgt.

8. Verfahren nach einem der obigen Ansprüche, **dadurch gekennzeichnet, daß** zur Autofokus-Kalibrierung eine fluoreszierende Flüssigkeit verwendet wird.

9. Mikroskop zum Laserbearbeiten eines Werkstückes (2) mittels Zwei-Photonen-Prozessen, das ein Objektiv (20), das eine in einem Werkstücksraum liegende Fokusebene aufweist, eine Bearbeitungslaserstrahlquelle (42), die Bearbeitungslaserstrahlung (14) abgibt, welche das Objektiv (20) in den Werkstückraum fokussiert, aufweist, und durch eine Autofokuseinrichtung gekennzeichnet ist, die umfaßt einen Lichtmodulator (28, 29) zur Erzeugung eines leuchtenden, intensitätsmodulierten Modulationsobjektes, eine Autofokus-Optik (27), die zusammen mit dem Objektiv (20) das leuchtende Modulationsobjekt in die Fokusebene oder diese schneidend abbildet, so daß im Werkstückraum ein Bild des Modulationsobjektes entsteht, eine Kamera (15) zur Aufnahme eines zweidimensionalen Bildes, die eine Kamera-Bildebene hat, und eine Autofokus-Abbildungsoptik (27, 43), die zusammen mit dem Objektiv (20) das im Werkstückraum liegende Bild des Modulationsobjektes in eine Autofokus-Bildebene abbildet, wobei die Kamera-Bildebene entweder die Autofokus-Bildebene schneidet, wenn das Bild des Modulationsobjektes in der Fokusebene liegt, oder in der Autofokus-Bildebene liegt, wenn das Bild des Modulationsobjektes die Fokusebene schneidet.

10. Mikroskop nach Anspruch 9, **dadurch gekennzeichnet, daß** der Lichtmodulator (28) ansteuerbar und zur Erzeugung eines räumlich oder zeitlich intensitätsmodulierten Modulationsobjektes angesteuert ist und die Kamera (15) den Kontrast zu dieser zeitlichen Modulation erfaßt, wobei vorzugsweise der Lichtmodulator (28) ein beleuchtetes LCD- oder DMD-Element oder mindestens eine periodische Struktur, insbesondere eine Streifengitterstruktur oder mehrere unterschiedliche Streifenstrukturen, aufweist.

11. Mikroskop nach Anspruch 9 oder 10, **dadurch gekennzeichnet, daß** die Abbildung des Modulationsobjektes über einen Strahlteiler (22) in den Mikroskopstrahlengang (13) eingespiegelt ist.

12. Mikroskop nach einem der Ansprüche 9 bis 11, **dadurch gekennzeichnet, daß** die Autofokus-Abbildungsoptik mindestens einen Filter (50) aufweist, der Spektralanteile der Bearbeitungslaserstrahlung (14) unterdrückt oder ausfiltert.

13. Mikroskop nach einem der Ansprüche 9 bis 12, **dadurch gekennzeichnet, daß** die Autofokus-Abbildungsoptik eine der Kamera (15) vorgeordnete Optik (43) aufweist und so das Bild des Modulationsobjekts mit einer Zwischenabbildung (44) auf der Kamera (15) abbildet.

14. Mikroskop nach einem der Ansprüche 9 bis 13, **gekennzeichnet durch** einen Längs-Verstellmechanismus (54) zur Verstellung des Abstandes zwischen der Kamera (15) und der Autofokus-Abbildungsoptik (43), wobei der Längs-Verstellmechanismus (54) eine Lagerückmeldung, welche den Verstellweg über ein Wegsignal anzeigt, aufweist.

15. Mikroskop nach einem der Ansprüche 8 bis 14, **gekennzeichnet durch** ein Steuergerät (26), welches das Winkelsignal empfängt und mittels Ansteuerung des Winkel-Verstellmechanismus die Autofokusauflösung einstellt.

16. Mikroskop nach einem der Ansprüche 8 bis 15, **dadurch gekennzeichnet, daß** eine Steuereinheit (18) vorgesehen ist, die so ausgebildet ist, daß sie am Mikroskop einen Betrieb gemäß einem der Ansprüche 1 bis 8 einstellt.

## Claims

1. A method for laser beam machining of a workpiece (2), wherein a laser beam (14) is focused by an objective (20) having a focal plane into or onto the workpiece (2), which has a boundary surface, to produce a machining effect by two-photon processes, and the position of the focus with respect to the workpiece (2) is shifted, **characterized in that** to reference the position of the focus, an illuminating modulation object is projected onto the workpiece (2), likewise by the objective (20), in the focal plane or so as to intersect the focal plane, reflections of the image occurring at the boundary surface are projected into an autofocus image plane, and are detected by a camera (15) having a camera image plane, wherein the camera image plane either intersects the autofocus image plane when the image of the illuminating modulation object lies in the focal plane, or lies in the autofocus image plane when the image of the modulation object intersects the focal plane.

2. The method according to Claim 1, **characterized in that** a cover glass (38) is placed over the workpiece (2), and the workpiece/cover glass interface is used as the boundary surface.

3. The method according to Claim 1 or 2, **characterized in that** the modulation object (28) illuminates within a spectral range that differs from that of the laser beam (14), and the spectral range of the laser beam (14) is filtered out during detection with the camera (15).

4. The method according to one of the preceding claims, **characterized in that** the position of the boundary surface is determined at least intermittently during the laser beam machining and used as a reference for setting the position of the focus.

5. The method according to one of the preceding claims, **characterized in that** prior to the laser beam machining, the position of the boundary surface is determined at various lateral points and modeled by a plane in order to more precisely determine the position of the full boundary surface.

6. The method according to Claim 5, **characterized in that** a measure of a deviation of the boundary surface from an ideal plane is determined from distances of the position of the lateral points from the modeled plane, and a quality parameter based on the measure is assigned to the workpiece, wherein further machining of the workpiece is suppressed in particular if a specific quality parameter range is present.

7. The method according to one of the preceding claims, **characterized in that** the workpiece (2) is machined by shifting the position of the focus three-dimensionally, wherein the focal point is shifted in planes that are in each case completely processed in succession and situated either parallel or perpendicular to the boundary surface, wherein the boundary surface is referenced once for each plane.

8. The method according to one of the preceding claims, **characterized in that** a fluorescent fluid is used for the autofocus calibration.

9. A microscope for laser machining of a workpiece (2) by two-photon processes, comprising an objective (20) that has a focal plane lying in a workpiece space, has a machining laser beam source (42) that emits machining laser radiation (14) which the objective (20) focuses into the workpiece space, and is **characterized by** an autofocus device which comprises a light modulator (28, 29) for generating an illuminating, intensity-modulated modulation object, autofocus optics (27) which, together with the objective (20), project the illuminating modulation object into the focal plane or into a plane intersecting the focal plane in such a way that an image of the modulation object is produced in the workpiece space, a camera (15) for recording a two-dimensional image that has a camera image plane, and autofocus imaging optics (27, 43) which, together with the objective (20), project the image of the modulation object situated in the workpiece space into an autofocus image plane, wherein the camera image plane either intersects the autofocus image plane when the image of the modulation object lies in the focal plane, or lies in the autofocus image plane when the image of the modulation object intersects the focal plane.

10. The microscope according to Claim 9, **characterized in that** the light modulator (28) is controllable and is controlled to generate a spatially or temporally intensity-modulated modulation object, and the camera (15) detects the contrast with respect to this temporal modulation, wherein the light modulator (28) preferably comprises an illuminated LCD or DMD element or at least one periodic structure, in particular a strip grating structure or multiple different strip structures.

11. The microscope according to Claim 9 or 10, **characterized in that** the projection of the modulation object is reflected via a beam splitter (22) into the microscope beam path (13).

12. The microscope according to one of Claims 9 to 11, **characterized in that** the autofocus imaging optics comprise at least one filter (50) which suppresses or filters out spectral components of the machining laser radiation (14).

13. The microscope according to one of Claims 9 to 12, **characterized in that** the autofocus imaging optics comprise optics (43), situated upstream from the camera (15), which project the image of the modulation object with an intermediate image (44) onto the camera (15).

14. The microscope according to one of Claims 9 to 13, **characterized by** a longitudinal adjusting mechanism (54) for adjusting the distance between the camera (15) and the autofocus imaging optics (43), wherein the longitudinal adjusting mechanism (54) includes position feedback which indicates the adjusting path via a path signal.

15. The microscope according to one of Claims 8 to 14, **characterized by** a control device (26) that receives the angle signal and sets the autofocus resolution by triggering the angle adjusting mechanism.

16. The microscope according to one of Claims 8 to 15, **characterized in that** a control unit (18) is provided which is designed in such a way that it sets an operation according to one of Claims 1 to 8 on the microscope.

## Revendications

1. Procédé d'usinage d'une pièce (2) par faisceau laser, un faisceau laser (14) étant concentré en un foyer par un objectif (20) qui présente un plan focal, dans ou sur la pièce (2) présentant une surface limite, afin de produire un effet d'usinage au moyen de processus à deux photons, et la position du foyer par rapport à la pièce (2) étant déplacée, **caractérisé en ce que** afin de référencer la position du foyer, l'objectif (20) projette également sur la pièce (2), dans le plan focal ou en croisant celui-ci, un objet lumineux de modulation, les réflexions de la projection qui apparaissent sur la surface limite sont reproduites dans un plan d'image de mise au point automatique, et sont détectées au moyen d'une caméra (15) présentant un plan d'image de caméra, le plan d'image de caméra soit croisant le plan d'image de mise au point automatique, si l'image de l'objet lumineux de modulation se situe dans le plan focal, soit se situant dans le plan d'image de mise au point automatique, si l'image de l'objet de modulation croise le plan focal.

2. Procédé selon la revendication 1, **caractérisé en ce qu'**un verre protecteur (38) est posé au-dessus de la pièce (2) et la transition pièce/verre protecteur sert de surface limite.

3. Procédé selon la revendication 1 ou 2, **caractérisé en ce que** l'objet de modulation (28) s'illumine dans une plage spectrale qui est différente de celle du faisceau laser (14), et **en ce que** la plage spectrale du faisceau laser (14) est filtrée lors de la détection au moyen de la caméra (15).

4. Procédé selon l'une quelconque des revendications précédentes, **caractérisé en ce que** pendant l'usinage par faisceau laser, la position de la surface limite est déterminée au moins par intermittence et utilisée comme référence pour le réglage de la position du foyer.

5. Procédé selon l'une quelconque des revendications précédentes, **caractérisé en ce que**, avant l'usinage par faisceau laser, la position de la surface limite en différents points latéraux est déterminée et modélisée à travers un plan, afin de déterminer avec plus de précision la position de la surface limite.

6. Procédé selon la revendication 5, **caractérisé en ce qu'**une grandeur concernant un écart entre la surface limite et un plan idéal est déduite des distances entre la position des points latéraux et le plan modélisé et un paramètre de qualité est associé à la pièce, lequel se base sur la grandeur, un autre usinage de la pièce étant empêché en particulier en présence d'une plage de paramètres de qualité déterminée.

7. Procédé selon l'une quelconque des revendications précédentes, **caractérisé en ce que** la pièce (2) est usinée du fait que la position du foyer est déplacée de manière tridimensionnelle, le foyer étant déplacé dans des plans qui sont usinés chacun intégralement les uns à la suite des autres et qui se situent soit parallèlement soit perpendiculairement à la surface limite, un référencement étant réalisé sur la surface limite dans chaque cas pour chaque plan.

8. Procédé selon l'une quelconque des revendications précédentes, **caractérisé en ce qu'**un liquide fluorescent est utilisé pour l'étalonnage de la mise au point automatique.

9. Microscope pour l'usinage d'une pièce (2) par laser au moyen de processus à deux photons, qui comprend un objectif (20) qui présente un plan focal situé dans un espace de pièce, une source de faisceau laser d'usinage (42), qui délivre un faisceau laser d'usinage (14), lequel focalise l'objectif (20) dans l'espace de la pièce, et **caractérisé par** un dispositif de mise au point automatique, qui comprend un modulateur de lumière (28, 29) servant à produire un objet lumineux de modulation modulé en intensité, une optique de mise au point automatique (27), qui reproduit conjointement avec l'objectif (20) l'objet lumineux de modulation dans le plan focal ou en croisant celui-ci, de sorte qu'une image de l'objet de modulation est obtenue dans l'espace de la pièce, une caméra (15) destinée à prendre une image bidimensionnelle, qui présente un plan d'image de caméra, et une optique de reproduction à mise au point automatique (27, 43), qui reproduit conjointement avec l'objectif (20) l'image, située dans l'espace de la pièce, de l'objet de modulation dans un plan d'image de mise au point automatique, le plan d'image de la caméra soit croisant le plan d'image de mise au point automatique, si l'image de l'objet de modulation se situe dans le plan focal, soit se situant dans le plan d'image de mise au point automatique, lorsque l'image de l'objet de modulation croise le plan focal.

10. Microscope selon la revendication 9, **caractérisé en ce que** le modulateur de lumière (28) peut être commandé et est commandé pour produire un objet de modulation modulé en intensité dans l'espace ou dans le temps et la caméra (15) détecte le contraste par rapport à cette modulation dans le temps, le modulateur de lumière (28) comprenant de préférence un élément LCD ou DMD éclairé ou au moins une structure périodique, en particulier une structure réticulaire en bandes ou plusieurs structures en bandes différentes.

11. Microscope selon la revendication 9 ou 10, **caractérisé en ce que** la reproduction de l'objet de modulation est réfléchie dans la trajectoire du faisceau du microscope (13) par un séparateur de faisceaux (22).

12. Microscope selon l'une quelconque des revendications 9 à 11, **caractérisé en ce que** l'optique de reproduction de mise au point automatique comprend au moins un filtre (50), qui supprime ou élimine par filtrage des parts spectrales du faisceau laser d'usinage (14).

13. Microscope selon l'une quelconque des revendications 9 à 12, **caractérisé en ce que** l'optique de reproduction à mise au point automatique comprend une optique (43) montée en amont de la caméra (15) et reproduit ainsi l'image de l'objet de modulation sur la caméra (15) au moyen d'une reproduction intermédiaire (44).

14. Microscope selon l'une quelconque des revendications 9 à 13, **caractérisé par** un mécanisme de déplacement longitudinal (54) permettant de déplacer la distance entre la caméra (15) et l'optique de reproduction à mise au point automatique (43), le mécanisme de déplacement longitudinal (54) comprenant une information en retour de position, laquelle indique le trajet de déplacement par l'intermédiaire d'un signal de trajet.

15. Microscope selon l'une quelconque des revendications 8 à 14, **caractérisé par** un appareil de commande (26), lequel reçoit le signal angulaire et règle la résolution de la mise au point automatique au moyen d'une commande du mécanisme de déplacement angulaire.

16. Microscope selon l'une quelconque des revendications 8 à 15, **caractérisé en ce qu'**une unité de commande (18) est prévue, qui est conçue pour régler un fonctionnement selon l'une quelconque des revendications 1 à 8 sur le microscope.
